# EUROPEAN PATENT SPECIFICATION

(11) **EP 2 051 285 B1**
(45) Date of publication and mention of the grant of the patent: **24.08.2011**
(21) Application number: 08017927.8
(22) Date of filing: 13.10.2008
(51) Int. Cl.: H01L 21/00, H01L 21/687, B08B 3/02

(54) **Substrate cleaning apparatus**
Substratreinigungsvorrichtung
Appareil de nettoyage de substrat

(30) Priority: 17.10.2007 JP 2007270330; 30.05.2008 JP 2008142672
(43) Date of publication of application: 22.04.2009
(73) Proprietor: EBARA CORPORATION, Ohta-ku, Tokyo (JP)
(72) Inventor: Morisawa, Shinya, Tokyo (JP); Matsuda, Naoki, Tokyo (JP); Kojima, Yasushi, Tokyo (JP)
(74) Representative: Emde, Eric

(56) References cited:
- JP-A- 10 041 269
- JP-A- 10 258 249
- US-A1- 2003 101 928
- US-A1- 2006 102 069

## Description

### BACKGROUND OF THE INVENTION

### Field of the Invention:

The present invention relates to a substrate cleaning apparatus for cleaning a substrate by supplying a cleaning solution, such as pure water or a chemical solution, to the substrate, and drying the cleaned substrate.

### Description of the Related Art:

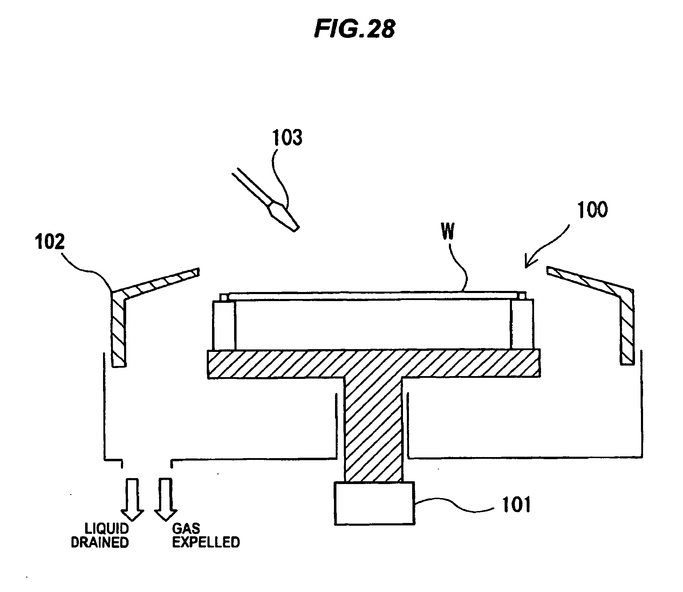

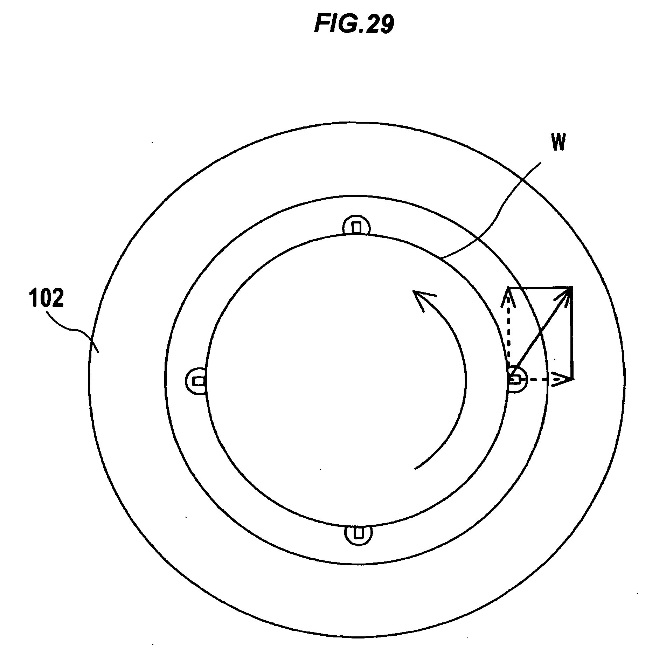

In the process of manufacturing semiconductor devices, cleaning of a substrate is an important process for increasing a yield of products. This substrate cleaning process is performed, for example, after a substrate polishing process to remove unwanted debris from the substrate. FIGS. 28 and 29 of the accompanying drawings show an example of a substrate cleaning apparatus. As shown in FIGS. 28 and 29, the substrate cleaning apparatus has a substrate holding mechanism 100 configured to hold a substrate W, a motor 101 configured to rotate the substrate holding mechanism 100, a stationary cover 102 provided around the substrate W, and a nozzle 103 for supplying pure water as a cleaning solution onto a surface of the substrate W so as to clean the substrate W During cleaning of the substrate W, the substrate W is rotated at a low speed and the pure water is supplied onto the surface of the substrate W During drying of the substrate W, the substrate W is rotated at a high speed of about 1500 min⁻¹, for example, to expel the pure water off the surface of the substrate W The pure water, removed from the substrate W, is captured by the stationary cover 102 and recovered.

When the pure water impinges upon the stationary cover 102, the pure water may bounce back as droplets, which may be attached again to the surface of the substrate W In addition, the high-speed rotation of the substrate W generates a swirling flow of air within the stationary cover 102. This swirling flow of air carries fine droplets of pure water (i.e., a mist of pure water), which are also attached to the surface of the substrate W The droplets and the mist of the pure water that are attached to the surface of the substrate W form water marks thereon. These water marks could adversely affect devices formed on the substrate W, resulting in a reduction in the yield of the products. Use of a chemical solution as the cleaning solution, other than pure water, could also cause back contamination of the substrate W for the same reasons. Therefore, it is increasingly important to prevent the production of the water marks and the back contamination of the substrate W.

Recently, Rotagoni drying has been proposed as a drying process for preventing the production of the water marks on the substrate. According to Rotagoni drying, IPA vapor (a mixture of isopropyl alcohol and an N₂ gas) and pure water are supplied from two parallel nozzles onto the surface of the rotating substrate, while the respective nozzles are moved in a radial direction of the substrate so as to dry the surface of the substrate. This Rotagoni drying process is capable of sufficiently drying the substrate even when the substrate is rotated at a relatively low speed ranging from, for example, 150 to 300 min⁻¹. However, even when the substrate is rotated at 300 min⁻¹ or less, the pure water may be turned into droplets or a mist when the pure water impinges upon the stationary cover. These droplets and the mist could be attached to the surface of the substrate.

Attention is drawn to US 2003/0101928 A, which shows a dual cup spin coating system for capturing a discharged flowable coating material in a spin coating process. The system has a rotatable substrate holding mechanism and a dual, cup system having a first outer cup and a second outer cup which may also be rotatable. The first outer cup is concentrically disposed around the second outer cup, thereby forming a first capture space arranged for capturing at least a portion of a discharged flowable coating material discharged from a processed substrate at a first positive angle with respect to the process substrate in a spin coating process. The inner cup is disposed concentrically within the second outer cup forming a second capture space arranged for capturing at least a second portion of the discharged flowable coating material discharged from the process substrate at a second positive angle less than about the first positive angle with respect to the process substrate in a spin coating process. Reference is also made to prior art document SP-A-10041269.

### SUMMARY OF THE INVENTION

In accordance with the present invention, an apparatus as set forth in claim 1 is provided. Preferred embodiments of the invention are claimed in the dependent claims.

It is an object of the present invention to provide a substrate cleaning apparatus capable of preventing the production of the water marks on the surface of the substrate and preventing the back contamination of the substrate.

To achieve the above object, the present invention according to one aspect provides a substrate cleaning apparatus including a substrate holding mechanism configured to hold a substrate horizontally, a rotating mechanism configured to rotate the substrate held by the substrate holding mechanism, a liquid supply nozzle for supplying a cleaning solution to the substrate, and a spin cover provided around the substrate and rotatable at substantially the same speed as the substrate. The spin cover has an inner circumferential surface shaped so as to surround the substrate, and the inner circumferential surface is, from a lower end to an upper end thereof, inclined radially inwardly.

In a preferred aspect of the present invention, the substrate cleaning apparatus further includes a stationary cover shaped so as to cover an entire outer circumferential of the spin cover.

In a preferred aspect of the present invention, the substrate cleaning apparatus further includes a relative movement mechanism configured to provide relative movement between the substrate and the spin cover along a rotational axis of the substrate.

In a preferred aspect of the present invention, the spin cover is mounted on the substrate holding mechanism, the substrate holding mechanism has a discharge hole having an upper opening positioned at a lower end of the spin cover, and the discharge hole is inclined downwardly outwardly.

In a preferred aspect of the present invention, the inner circumferential surface of the spin cover has a vertical cross section comprising a curved line, and an angle of the inner circumferential surface with respect to a horizontal plane increases gradually from a minimum at the upper end to a maximum at the lower end of the inner circumferential surface.

In a preferred aspect of the present invention, the substrate cleaning apparatus further includes a liquid absorber provided on the inner circumferential surface of the spin cover.

In a preferred aspect of the present invention, the substrate cleaning apparatus further includes an inner spin cover provided radially inwardly of the spin cover. The inner spin cover is rotatable together with the spin cover.

In a preferred aspect of the present invention, the inner spin cover has an outer circumferential surface having an arcuate vertical cross section, and the outer circumferential surface of the inner spin cover has an upper end lying at the same height as or slightly below an upper surface of the substrate held by the substrate holding mechanism.

In a preferred aspect of the present invention, the substrate cleaning apparatus further includes support arms configured to couple the inner spin cover and the spin cover to each other. The support arms is disposed in a gap between the inner spin cover and the spin cover and is shaped so as to produce a downward flow of a gas in the gap when the inner spin cover and the spin cover rotate

According to the present invention, since the spin cover rotates at substantially the same speed as the substrate, a relative speed between the substrate and the spin cover is substantially zero. Therefore, the cleaning solution hardly produce droplets and a mist when the cleaning solution impinges upon the spin cover. As a result, the production of the water marks and the back contamination of the substrate can be prevented. The cleaning solution, which is moved from the substrate to the spin cover, is quickly discharged downwardly along the inner circumferential surface of the spin cover under the centrifugal force. Therefore, the cleaning solution does not remain on the inner circumferential surface of the spin cover, and thus hardly produce the droplets and the mist thereof As the relative speed between the substrate and the spin cover is substantially zero, almost no swirling flow of a gas is formed inside the spin cover. Consequently, the mist of the cleaning solution is prevented from being carried by the swirling flow of the gas and attached to the substrate.

The above and other objects, features, and advantages of the present invention will become apparent from the following description when taken in conjunction with the accompanying drawings which illustrate preferred embodiments of the present invention by way of example.

### BRIEF DESCRIPTION OF THE DRAWINGS

FIG 1 is a schematic vertical cross-sectional view of a substrate cleaning apparatus according to a first embodiment of the present invention;
FIG 2 is a plan view of the substrate cleaning apparatus shown in FIG 1;
FIG 3 is a schematic vertical cross-sectional view of the substrate cleaning apparatus shown in FIG 1 with a substrate being elevated;
FIG 4 is a plan view of a substrate holding mechanism of the substrate cleaning apparatus shown in FIG 1;
FIG 5 is a view showing paths of a liquid flowing through the substrate cleaning apparatus shown in FIG 1;
FIG 6 is a view showing paths of a gas flowing through the substrate cleaning apparatus shown in FIG 1;
FIG 7 is an enlarged cross-sectional view showing a modification of an inner circumferential surface of a spin cover of the substrate cleaning apparatus according to the first embodiment;
FIG 8 is an enlarged cross-sectional view of the substrate cleaning apparatus according to the first embodiment with the substrate being elevated to an upper end of the spin cover;
FIG 9 is a schematic vertical cross-sectional view of a substrate cleaning apparatus according to a second embodiment of the present invention;
FIG 10 is a schematic vertical cross-sectional view of the substrate cleaning apparatus shown in FIG 9 with a substrate being elevated by push rods;
FIG 11 is an enlarged cross-sectional view showing a modification of a spin cover of the substrate cleaning apparatus according to the second embodiment;
FIG 12 is a schematic vertical cross-sectional view of a substrate cleaning apparatus according to a third embodiment of the present invention;
FIG 13 is a view showing paths of a gas flowing through the substrate cleaning apparatus shown in FIG 12;
FIG 14 is a schematic vertical cross-sectional view showing a modification of the substrate cleaning apparatus according to the third embodiment;
FIG 15 is a schematic vertical cross-sectional view of a substrate cleaning apparatus according to a fourth embodiment of the present invention;
FIG 16 is a schematic vertical cross-sectional view of a substrate cleaning apparatus according to a fifth embodiment of the present invention;
FIG 17 is a schematic vertical cross-sectional view of a substrate cleaning apparatus according to a reference example of the present invention;
FIG 18 is a schematic vertical cross-sectional view of a substrate cleaning apparatus according to another reference example of the present invention;
FIG 19 is a schematic vertical cross-sectional view of a substrate cleaning apparatus according to still another reference example of the present invention;
FIG 20 is a schematic vertical cross-sectional view of the substrate cleaning apparatus according to still another reference example of the present invention;
FIG 21 is a schematic vertical cross-sectional view of a substrate cleaning apparatus according to a sixth embodiment of the present invention;
FIG 22A is an enlarged vertical cross-sectional view of an inner spin cover and an outer spin cover;
FIG 22B is a plan view of the inner spin cover and a chuck;
FIG 23A is a plan view of support arms fixed to the inner spin cover, as viewed from above;
FIG 23B is a view of the support arms shown in FIG 23A, as viewed from a radially outward side;
FIG 24 is a schematic vertical cross-sectional view showing a modification of the substrate cleaning apparatus according to the sixth embodiment of the present invention with a stationary cover added;
FIG 25 is a plan view of a polishing apparatus incorporating the substrate cleaning apparatus according to any one of the first to sixth embodiments of the present invention;
FIG 26 is a schematic perspective view of the polishing apparatus shown in FIG 25;
FIG 27 is a plan view of another polishing apparatus incorporating the substrate cleaning apparatus according to any one of the first to sixth embodiments of the present invention;
FIG 28 is a schematic vertical cross-sectional view of a conventional substrate cleaning apparatus; and
FIG 29 is a plan view of the substrate cleaning apparatus shown in FIG 28.

### DETAILED DESCRIPTION OF THE PREFERRED EMBODIMENTS

A substrate cleaning apparatus according to embodiments of the present invention will be described below with reference to the drawings. Like or corresponding parts are denoted by like or corresponding reference characters.

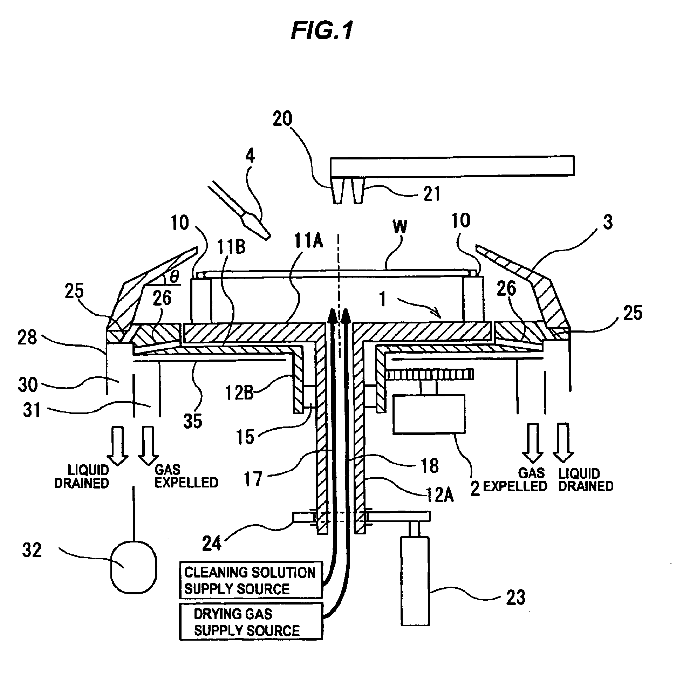

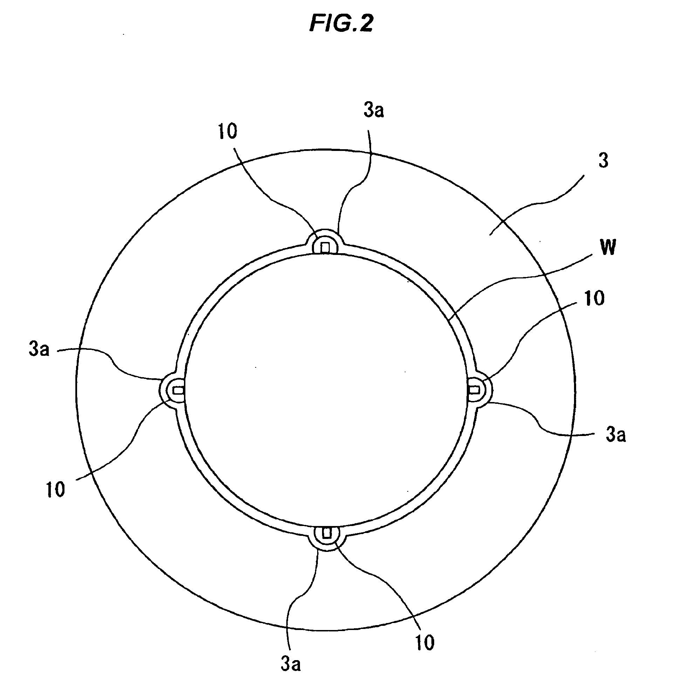

FIG 1 is a schematic vertical cross-sectional view of a substrate cleaning apparatus according to a first embodiment of the present invention, and FIG 2 is a plan view of the substrate cleaning apparatus shown in FIG 1.

As shown in FIG 1, the substrate cleaning apparatus includes a substrate holding mechanism 1 configured to hold a substrate W horizontally, a motor (rotating mechanism) 2 configured to rotate the substrate W about its own central axis via the substrate holding mechanism 1, a spin cover 3 provided around the substrate W, and a front nozzle 4 for supplying pure water as a cleaning solution onto a surface (front surface) of the substrate W A chemical solution, other than pure water, may be used as the cleaning solution.

The substrate holding mechanism 1 includes a plurality of chucks 10 configured to grip a peripheral edge of the substrate W, a circular first stage 11A on which the chucks 10 are mounted, a hollow first support shaft 12A supporting the first stage 11A, a circular second stage 11B having a recess in which the first stage 11A is housed, and a hollow second support shaft 12B supporting the second stage 11B. The first support shaft 12A extends through the second support shaft 12B. The first stage 11A, the second stage 11B, the first support shaft 12A, and the second support shaft 12B are concentrically arranged. The spin cover 3 is fixed to a periphery of the second stage 11B. The second stage 11B and the spin cover 3 are concentrically arranged. The substrate W, held by the chucks 10, and the spin cover 3 are concentrically positioned.

The first support shaft 12A and the second support shaft 12B are coupled to each other by a linear-motion guide mechanism 15. This linear-motion guide mechanism 15 is configured to transmit a torque between the first support shaft 12A and the second support shaft 12B, while allowing the first support shaft 12A and the second support shaft 12B to move relative to each other in their longitudinal direction, i.e., along their rotational axes. Specific examples of the linear-motion guide mechanism 15 include a ball spline bearing.

The motor 2 is coupled to an outer circumferential surface of the second support shaft 12B via gears. A torque of the motor 2 is transmitted via the linear-motion guide mechanism 15 to the first support shaft 12A to thereby rotate the substrate W held by the chucks 10. Rotation of the first stage 11A and rotation of the second stage 11B are in synchronism with each other at all times due to the linear-motion guide mechanism 15. Specifically, the substrate W and the spin cover 3 are rotatable integrally with each other, with a relative speed therebetween being zero. It is possible that there is a slight speed difference between the substrate W and the spin cover 3. The substrate W and the spin cover 3 may be rotated by different rotating mechanisms. In this specification, rotating the substrate W and the spin cover 3 at substantially the same speed means rotating the substrate W and the spin cover 3 in the same direction at substantially the same angular velocity, but does not mean rotating the substrate W and the spin cover 3 in opposite directions.

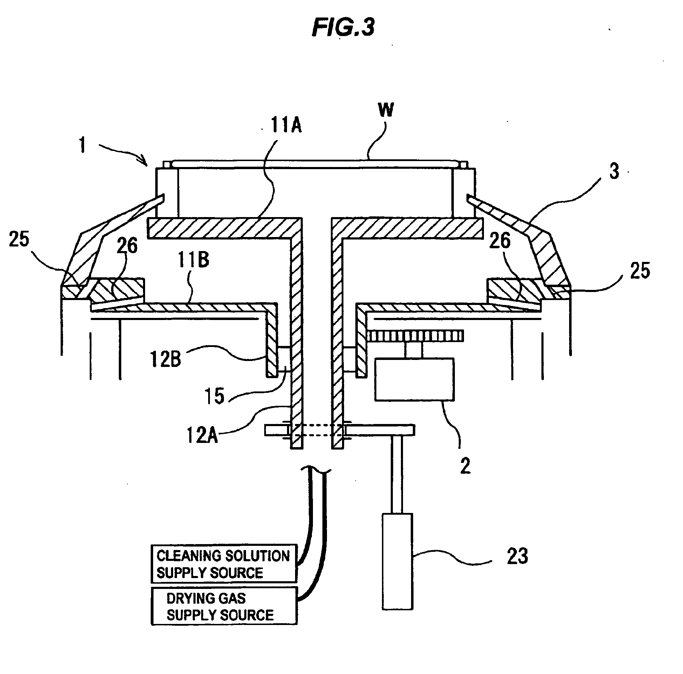

An actuator 23, serving as a vertically moving mechanism, is coupled to the first support shaft 12A via a coupling mechanism 24. This coupling mechanism 24 is configured to transmit a drive force of the actuator 23, which acts in the rotating axial direction, to the first support shaft 12A, while allowing the first support shaft 12A to rotate about its own axis. As shown in FIG 3, the actuator 23 moves the first stage 11A, the first support shaft 12A, and the chucks 10 (i.e., the substrate W) vertically via the coupling mechanism 24. The actuator 23 thus constitutes a relative movement mechanism for providing relative movement between the substrate W and the spin cover 3 along the rotational axis.

The first support shaft 12A houses therein a back nozzle 17 coupled to a cleaning solution supply source and a gas nozzle 18 coupled to a drying gas supply source. The cleaning solution supply source stores pure water as a cleaning solution therein and supplies the pure water through the back nozzle 17 to a rear surface of the substrate W The drying gas supply source stores an N₂ gas or dry air as a drying gas therein, and supplies the drying gas through the gas nozzle 18 to the rear surface of the substrate W

The front nozzle 4 is oriented toward the center of the substrate W The front nozzle 4 is coupled to a pure water supply source (i.e., a cleaning solution supply source), not shown in the drawings, and supplies pure water from the pure water supply source to the center of the front surface of the substrate W Two parallel nozzles 20 and 21 for performing Rotagoni drying are disposed above the substrate W The nozzle 20 is for supplying IPA vapor (a mixture of isopropyl alcohol and an N₂ gas) onto the front surface of the substrate W The nozzle 21 is for supplying pure water onto the front surface of the substrate W in order to prevent the front surface of the substrate W from being dried. The nozzles 20 and 21 are movable in the radial direction of the substrate W.

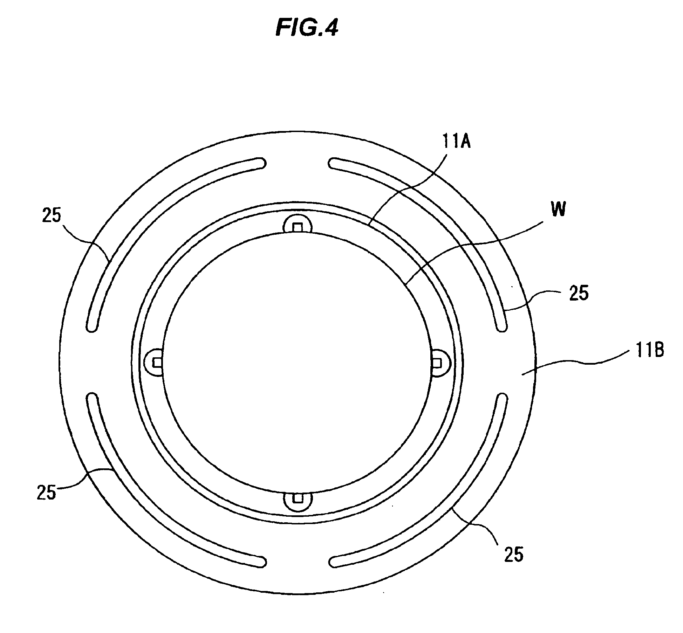

FIG 4 is a plan view of the substrate holding mechanism 1. As shown in FIGS. 1 and 4, the second stage 11B has a plurality of discharge holes 25 defined therein. The discharge holes 25 have upper openings positioned at a lower end of the spin cover 3 and lower openings lying in a lower surface of the second stage 11B. As shown in FIG 4, the discharge holes 25 are oblong holes extending in a circumferential direction of the spin cover 3, and are inclined radially outwardly toward their lower openings. The cleaning solution (e.g., pure water) supplied from the front nozzle 4 and the back nozzle 17 and the pure water supplied from the nozzle 21, as well as the gas from the gas nozzle 18 and an ambient atmosphere (typically air), are discharged through the discharge holes 25.

The second stage 11B also has a plurality of auxiliary discharge holes 26 for discharging a liquid (the cleaning solution, the pure water) trapped between the first stage 11A and the second stage 11B. These auxiliary discharge holes 26 have upper openings positioned in a gap between the first stage 11A and the second stage 11B and lower openings lying in the lower surface of the second stage 11B. The auxiliary discharge holes 26 are inclined radially outwardly toward their lower openings, as with the discharge holes 25.

A liquid outlet passage 30 and a gas outlet passage 31 are provided below the lower openings of the discharge holes 25 and the auxiliary discharge holes 26. The liquid outlet passage 30 and the gas outlet passage 31 are annular in shape. The liquid outlet passage 30 is located radially outwardly of the gas outlet passage 31. With this arrangement, the liquid and the gas that are discharged from the discharge holes 25 and the auxiliary discharge holes 26 are separated from each other by a centrifugal force, so that the liquid flows into the liquid outlet passage 30 and the gas flows into the gas outlet passage 31.

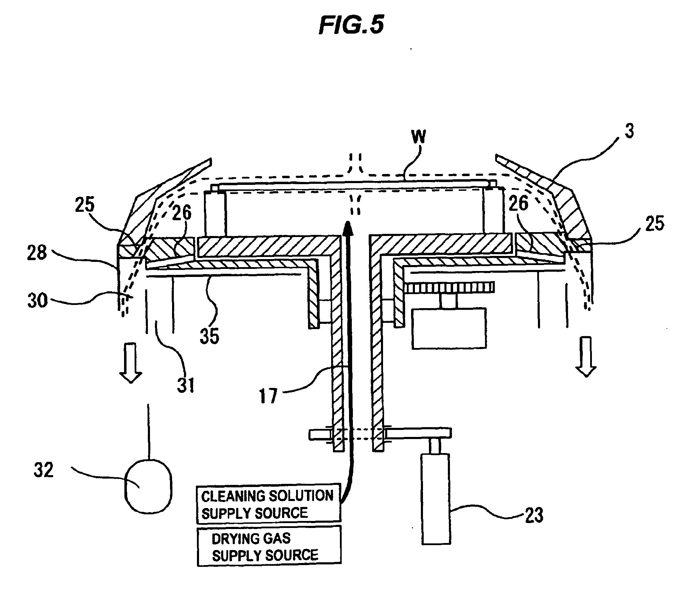

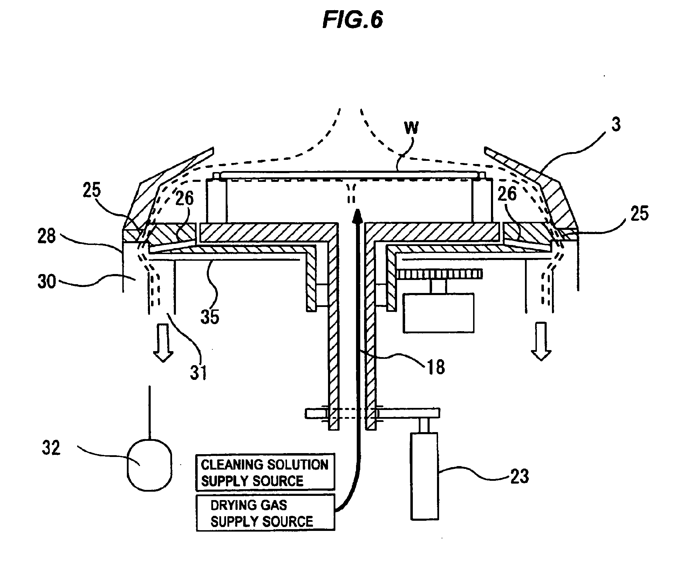

FIG 5 shows paths of the liquid, and FIG 6 shows paths of the gas. The gas outlet passage 31 is coupled to a suction source 32, such as a vacuum pump. As shown in FIG 6, operation of the suction source 32 creates a downward flow of the gas flowing from the front surface of the substrate W through the discharge holes 25 and the gas outlet passage 31.

A circular stationary plate 35 is provided beneath the second stage 11B with a small clearance from the lower surface of the second stage 11B. The stationary plate 35 serves to prevent an ambient gas from being stirred by the rotation of the second stage 11B. A downwardly extending tubular skirt 28 is fixed to the periphery of the second stage 11B. This skirt 28 serves to prevent scattering of the liquid discharged from the discharge holes 25 and the auxiliary discharge holes 26 and also serves to allow the liquid to be released in a position away from the substrate W

The spin cover 3 has an inner circumferential surface shaped so as to surround the substrate W held by the substrate holding mechanism 1. This inner circumferential surface of the spin cover 3 has an upper end positioned above the substrate W The inner circumferential surface is shaped such that a diameter thereof (i.e., an inside diameter of the spin cover 3) gradually decreases toward the upper end of the inner circumferential surface. In other words, the inner circumferential surface in its entirety is inclined radially inwardly toward the upper end thereof, and an angle θ (see FIG 1) between the inner circumferential surface and a horizontal plane is less than 90 degrees.

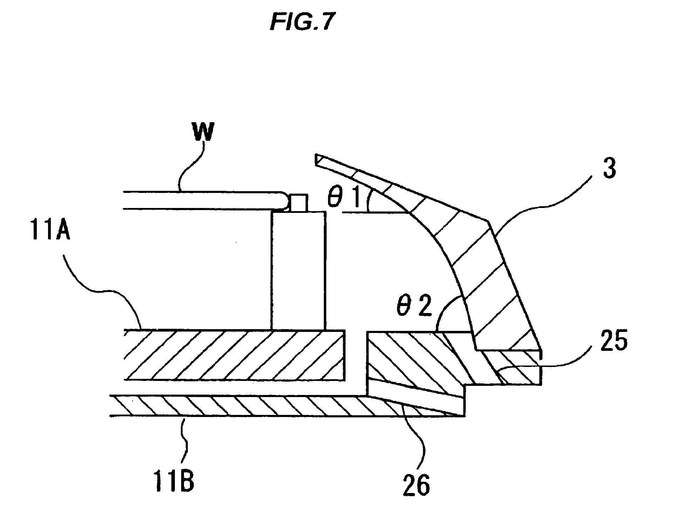

As shown in FIG 1, the inner circumferential surface of the spin cover 3 has a vertical cross section comprising two oblique lines. However, the vertical cross section of the inner circumferential surface of the spin cover 3 is not limited to this shape shown in FIG 1. As shown in FIG 7, the inner circumferential surface of the spin cover 3 may have a vertical cross section comprising a curved line, i.e., an arcuate vertical cross section. In FIG 7, the angle between the inner circumferential surface and the horizontal plane increases gradually from a minimum at the upper end to a maximum at the lower end of the spin cover 3 (θ1 < θ2). The inner circumferential surface of the spin cover 3 shown in FIG 7 can reduce an impact of the liquid impinging upon the spin cover 3 and allows the liquid to flow quickly along the inner circumferential surface downwardly due to the centrifugal force. The angle of the inner circumferential surface at its upper end with respect to the horizontal plane should preferably be substantially 0 degree.

As shown in FIG 2, the upper end of the spin cover 3 has a plurality of recesses 3a each having a shape corresponding to a shape of each chuck 10. The diameter of the upper end of the spin cover 3 is slightly greater than a diameter of the substrate W

As shown in FIG 1, the lower end of the spin cover 3 is positioned over a part of each upper opening of the discharge hole 25, so that the downward flow of the liquid along the inner circumferential surface of the spin cover 3 can be led smoothly into the discharge holes 25. If the upper openings of the discharge holes 25 are located away from the lower end of the spin cover 3, then the liquid, flowing downwardly along the inner circumferential surface of the spin cover 3, would hit the upper surface of the second stage 11B and would not flow smoothly into the discharge holes 25. According to the above-described arrangements of this embodiment, the liquid does not impinge upon the upper surface of the second stage 11B. Hence, the liquid flows smoothly into the discharge holes 25.

Operations of the substrate cleaning apparatus according to the first embodiment will be described below.

The motor 2 is energized to rotate the substrate W and the spin cover 3. In this state, the front nozzle 4 and the back nozzle 17 supply the pure water onto the front surface (upper surface) and the rear surface (lower surface) of the substrate W so as to rinse the substrate W in its entirety with the pure water. The pure water, supplied to the substrate W, spreads over the front surface and the rear surface via the centrifugal force, thereby rinsing all the surfaces of the substrate W The pure water, that is removed from the rotating substrate W, is captured by the spin cover 3 and flows into the discharge holes 25. While the substrate W is thus rinsed, the two nozzles 20 and 21 are in their given standby positions away from the substrate W.

Then, supply of the pure water from the front nozzle 4 is stopped, and the front nozzle 4 is moved to its given standby position away from the substrate W. The two nozzles 20 and 21 are moved to their operating positions above the substrate W. While the substrate W is being rotated at a low speed ranging from 150 to 300 min⁻¹, the nozzle 20 supplies the IPA vapor and the nozzle 21 supplies the pure water onto the front surface of the substrate W. During this operation, the back nozzle 17 supplies the pure water to the rear surface of the substrate W The two nozzles 20 and 21 are simultaneously moved in the radial direction of the substrate W, whereby the front surface (upper surface) of the substrate W is dried.

Thereafter, the two nozzles 20 and 21 are moved to their standby positions, and supply of the pure water from the back nozzle 17 is stopped. Then, the substrate W is rotated at a high speed ranging from 1000 to 1500 min⁻¹, removing the pure water from the rear surface of the substrate W. During this operation, the gas nozzle 18 supplies the drying gas to the rear surface of the substrate W. In this manner, the rear surface of the substrate W is dried.

While the front surface (upper surface) of the substrate W is dried, the pure water is supplied to the front surface and the rear surface of the substrate W, as described above. This pure water is removed from the substrate W and moved to the spin cover 3 by the centrifugal force. Because the spin cover 3 and the substrate W are rotated at the same speed, the pure water is hardly scattered when it impinges upon the inner circumferential surface of the spin cover 3. In addition, little swirling flow of gas is produced in a space between the spin cover 3 and the substrate W rotating at the same speed. Therefore, the mist of the pure water is not carried by the swirling flow to the substrate W. Consequently, the production of water marks on the substrate W are prevented. Furthermore, since the inner circumferential surface of the spin cover 3 is inclined radially inwardly, the centrifugal force, generated by the rotation of the spin cover 3, causes the pure water to flow quickly in the downward direction along the inner circumferential surface of the spin cover 3 into the discharge holes 25.

After drying of the substrate W is terminated, supply of the drying gas from the gas nozzle 18 is stopped. As shown in FIG 3, the actuator 23 elevates the substrate W until the substrate W is positioned above the spin cover 3. The dried substrate W is removed from the substrate holding mechanism 1 by a hand of a transfer robot (not shown in the drawings).

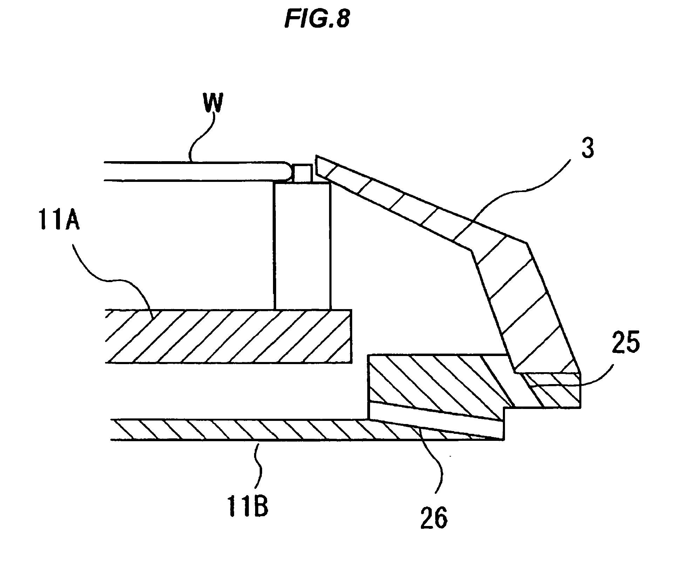

It is preferable that the substrate W be positioned at different heights when the front surface of the substrate W is dried and when the rear surface of the substrate W is dried. For example, when the front surface of the substrate W is dried, the substrate W is in a normal position shown in FIG 1. On the other hand, when the rear surface of the substrate W is dried, the substrate W is elevated to a position of the upper end of the spin cover 3. More specifically, the substrate W is elevated until the upper end of the inner circumferential surface of the spin cover 3 is positioned between the front surface and the rear surface of the substrate W, as shown in FIG 8. In this position shown in FIG 8, a distance between the substrate W and the spin cover 3 is minimized. Therefore, droplets and a mist are prevented from flowing from the rear surface to the front surface of the substrate W.

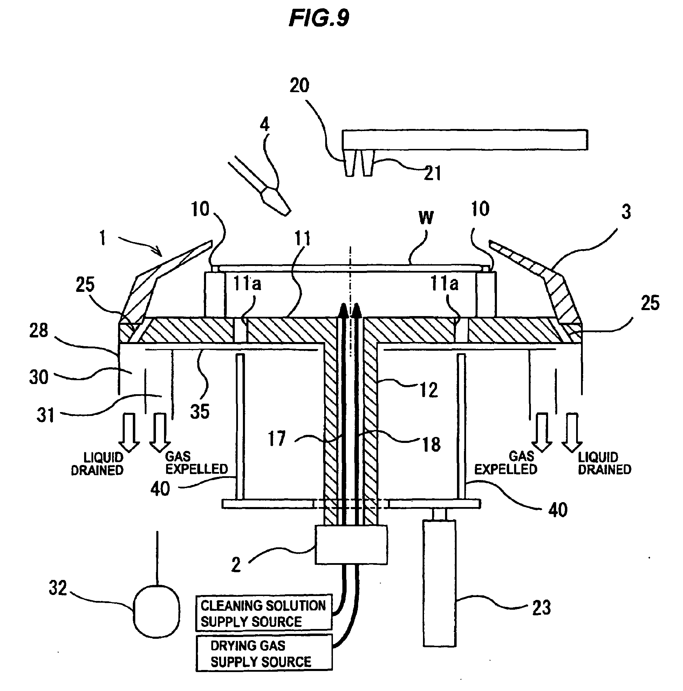

FIG 9 is a schematic vertical cross-sectional view of a substrate cleaning apparatus according to a second embodiment of the present invention. Those parts of the substrate cleaning apparatus according to the second embodiment, which are identical to those of the substrate cleaning apparatus according to the first embodiment, are denoted by identical reference characters, and will not be described in detail below. Operational details of the substrate cleaning apparatus according to the second embodiment, which will not be described below, are the same as those of the substrate cleaning apparatus according to the first embodiment.

According to the second embodiment, the substrate holding mechanism 1 includes a single stage 11, a hollow support shaft 12 supporting the stage 11, and a plurality of chucks 10 mounted on an upper surface of the stage 11. The spin cover 3 is fixed to a periphery of the stage 11. Relative position between the spin cover 3 and the substrate W is fixed at all times.

Below the stage 11, there are provided at least three push rods 40 and an actuator 23 for vertically moving these push rods 40. The stage 11 has a plurality of through-holes 11 a in positions corresponding to positions of the respective push rods 40. The stationary plate 35, disposed beneath the stage 11, also has a plurality of through-holes (not shown) in positions corresponding to the positions of the respective through-holes 11a. The stage 11 has no auxiliary discharge holes.

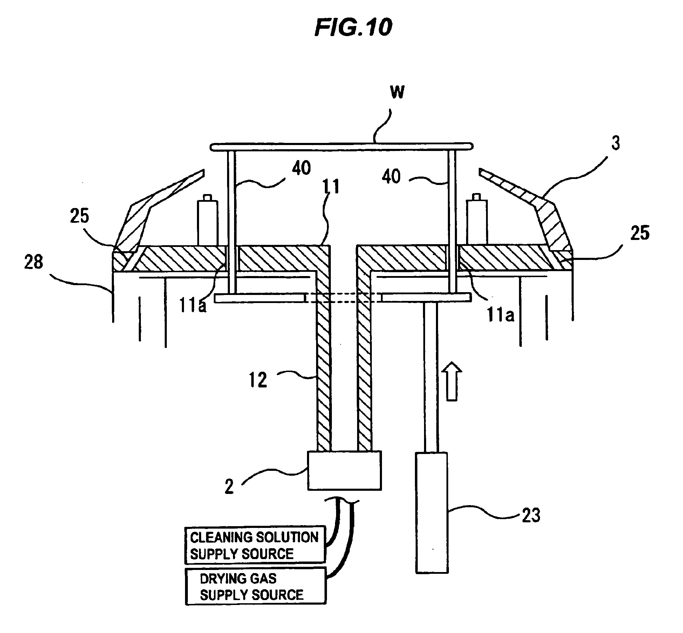

The substrate W is dried in the same operational sequence as with the first embodiment. After the substrate W is dried, the actuator 23 elevates the push rods 40, as shown in FIG 10, which move upwardly through the through-holes 11a to elevate the substrate W. Thereafter, the dried substrate W is removed by a hand of a transfer robot (not shown in the drawings).

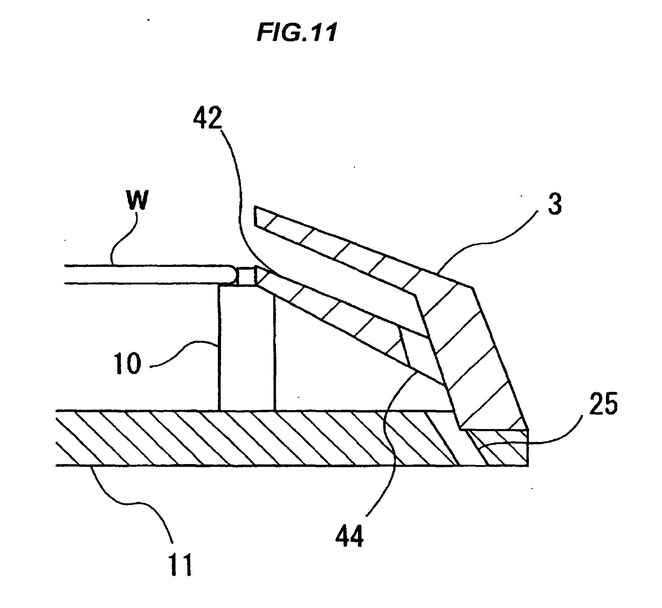

FIG 11 is an enlarged cross-sectional view showing a modification of the spin cover 3 of the substrate cleaning apparatus according to the second embodiment. As shown in FIG. 11, the spin cover 3 is combined with an auxiliary spin cover 42 which is fixed to the inner circumferential surface of the spin cover 3. The spin cover 3 and the auxiliary spin cover 42 rotate together with each other. The auxiliary spin cover 42 has an inner circumferential surface inclined radially inwardly toward its upper end. The upper end of the auxiliary spin cover 42 is positioned at substantially the same height as the substrate W. The upper end of the spin cover 3 and the upper end of the auxiliary spin cover 42 have substantially the same diameter. The upper end of the auxiliary spin cover 42 has a plurality of recesses (not shown in the drawing) which are similar in shape to the recesses 3a shown in FIG 2. The auxiliary spin cover 42 has a plurality of discharge holes 44 defined in its lower end.

A space above the front surface of the substrate W and a space beneath the rear surface of the substrate W are separated from each other by the auxiliary spin cover 42. Therefore, the process of drying the front surface of the substrate W and the process of drying the rear surface of the substrate W hardly affect each other. Specifically, the auxiliary spin cover 42 prevents the mist of the liquid from flowing between the space above the front surface and the space beneath the rear surface of the substrate W. In addition, it is possible to change the order of the drying process for the front surface and the drying process for the rear surface of the substrate W. Specifically, the rear surface of the substrate W can be dried first and then the front surface can be dried. The specific details of the drying processes are the same as those of the first embodiment.

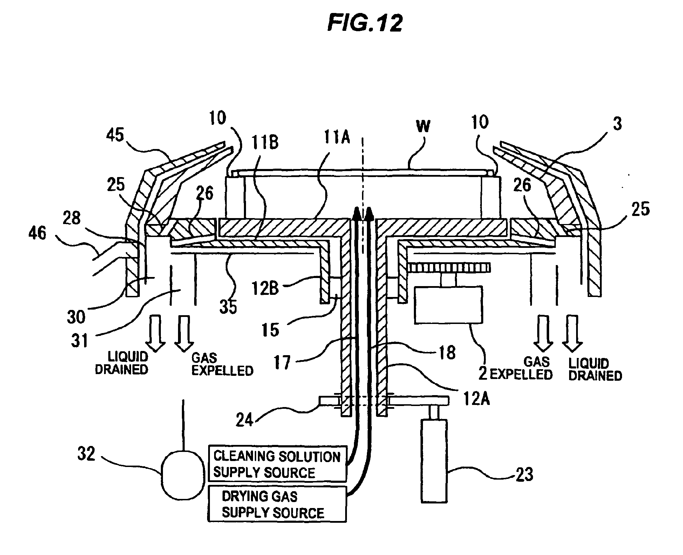

FIG 12 is a schematic vertical cross-sectional view of a substrate cleaning apparatus according to a third embodiment of the present invention. Those parts of the substrate cleaning apparatus according to the third embodiment, which are identical to those of the substrate cleaning apparatus according to the first embodiment, are denoted by identical reference characters, and will not be described in detail below. Operational details of the substrate cleaning apparatus according to the third embodiment, which will not be described below, are the same as those of the substrate cleaning apparatus according to the first embodiment.

The substrate cleaning apparatus according to the third embodiment is different from the substrate cleaning apparatus according to the first embodiment in that a stationary cover 45 is provided around the spin cover 3. This stationary cover 45 is not rotatable, and is shaped so as to cover an entire outer circumferential surface of the spin cover 3. A small gap is formed between the outer circumferential surface of the spin cover 3 and an inner circumferential surface of the stationary cover 45. The stationary cover 45 has an exhaust port 46. The stationary cover 45 has an upper end whose diameter is substantially the same as or slightly greater than the diameter of the upper end of the spin cover 3. The stationary cover 45 has a lower end positioned below the lower end of the skirt 28. Therefore, the stationary cover 45 is shaped so as to cover the entire outer circumferential surfaces of the spin cover 3 and the skirt 28.

The reasons for providing the stationary cover 45 are as follows. When the spin cover 3 rotates together with the substrate W, the spin cover 3 could disturb a gas around the outer circumferential surface thereof, producing a slight swirling flow of the gas. This swirling flow of the gas may carry a mist of the liquid back to the surface of the substrate W. The swirling flow of the gas may also carry a liquid on a wall of a cleaning chamber (i.e., cleaning space) and may carry an atmosphere in the cleaning chamber to the surface of the substrate W. The stationary cover 45 can prevent such swirling flow of the gas from being produced, and therefore prevent the production of the water marks on the substrate W and the back contamination of the substrate W.

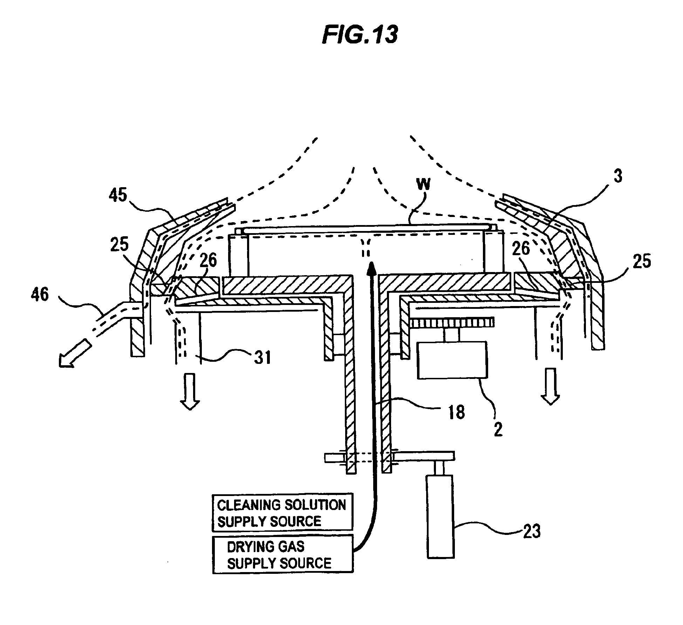

The gap between the stationary cover 45 and the spin cover 3 should preferably be as small as possible in order to prevent the gas in the gap from being disturbed by the rotation of the spin cover 3 and from flowing back toward the substrate W. The exhaust port 46 is preferably coupled to a suction source, not shown, for forcibly evacuating the gas from the gap between the stationary cover 45 and the spin cover 3 while the substrate W is being dried. When the suction source is operated, a flow of the gas is produced in the small gap between the spin cover 3 and the stationary cover 45, as shown in FIG 13. As a result, the gas, which has once flowed into the gap, does not flow back toward the substrate W during rotation of the spin cover 3.

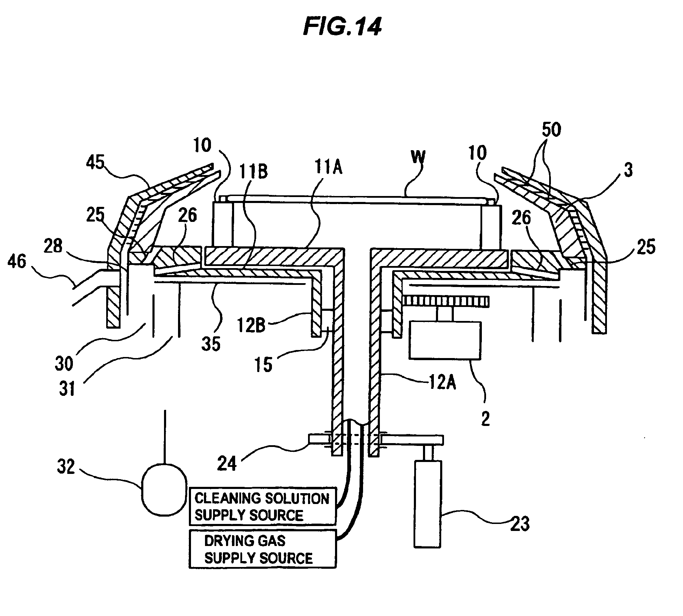

FIG 14 is a schematic vertical cross-sectional view showing a modification of the substrate cleaning apparatus according to the third embodiment of the present invention. As shown in FIG 14, a plurality of fins 50 are fixed to the outer circumferential surface of the spin cover 3. The fins 50 can prevent the gas, that has flowed into the gap between the stationary cover 45 and the spin cover 3, from flowing back with the rotation of the spin cover 3. The outer circumferential surface of the spin cover 3 may have a spiral groove, instead of the fins 50, for causing the gas in the gap to flow downwardly by the rotation of the spin cover 3.

The stationary cover 45 according to the third embodiment may be applied to the substrate cleaning apparatus according to the first and second embodiments.

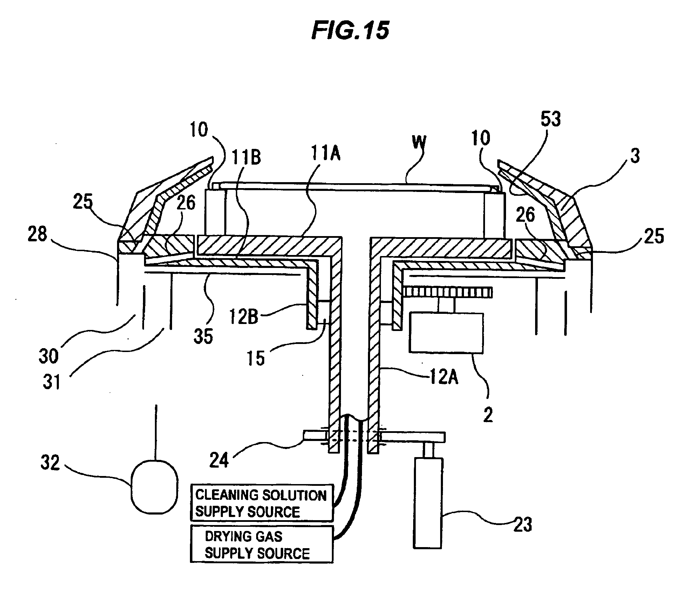

FIG 15 is a schematic vertical cross-sectional view of a substrate cleaning apparatus according to a fourth embodiment of the present invention. Those parts of the substrate cleaning apparatus according to the fourth embodiment, which are identical to those of the substrate cleaning apparatus according to the first embodiment, are denoted by identical reference characters, and will not be described in detail below. Operational details of the substrate cleaning apparatus according to the fourth embodiment, which will not be described below, are the same as those of the substrate cleaning apparatus according to the first embodiment.

As shown in FIG 15, a liquid absorber 53 is fixed to the inner circumferential surface of the spin cover 3. The liquid absorber 53 covers substantially the entire inner circumferential surface of the spin cover 3. The liquid absorber 53 may be made of a sponge of PVA (polyvinyl alcohol), a porous material, or a mesh cloth. The liquid absorber 53 should preferably be hydrophilic for easily trapping the liquid from the substrate W. The liquid absorber 53 should also preferably have continuous pores therein so as to lead the trapped liquid downwardly through the liquid absorber 53 to the discharge holes 25.

In the fourth embodiment with the above-described structures, the liquid absorber 53 is also able to absorb the impact of the liquid impinging upon the spin cover 3. The liquid absorber 53 is also applicable to the substrate cleaning apparatus according to the first through third embodiments.

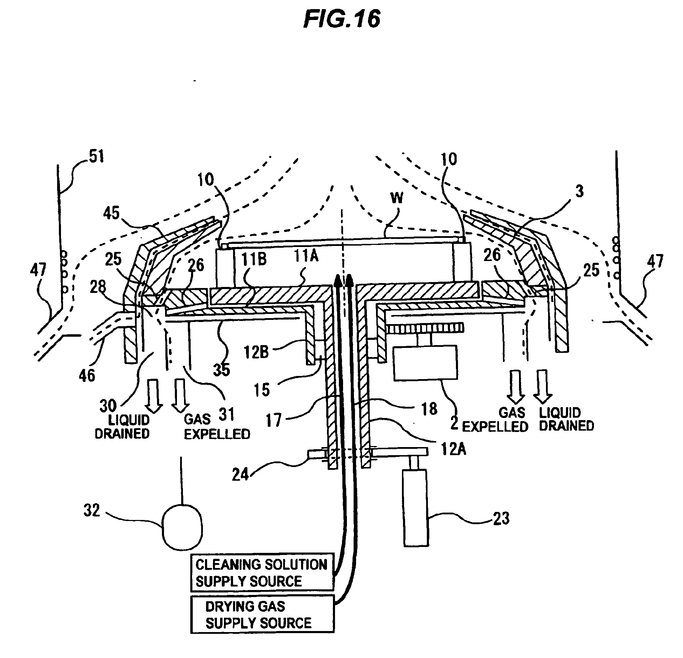

FIG 16 is a schematic vertical cross-sectional view of a substrate cleaning apparatus according to a fifth embodiment of the present invention. Those parts of the substrate cleaning apparatus according to the fifth embodiment, which are identical to those of the substrate cleaning apparatus according to the third embodiment, are denoted by identical reference characters, and will not be described in detail below. Operational details of the substrate cleaning apparatus according to the fifth embodiment, which will not be described below, are the same as those of the substrate cleaning apparatus according to the first embodiment.

As shown in FIG 16, a cleaning chamber 51 is disposed around the stationary cover 45, and exhaust ports 47 are provided in a lower portion of the cleaning chamber 51. The exhaust ports 47 and the exhaust port 46 of the stationary cover 45 are coupled to a suction source (not shown). According to this embodiment, operations of the non-illustrated suction source and the suction source 32, which is coupled to the gas outlet passage 31, form a downward flow of the gas in the cleaning chamber 51 in its entirety. Particularly, when the gas in the cleaning chamber 51 is discharged through the exhaust ports 47, a downward flow of the gas is formed along the outer circumferential surface of the stationary cover 45. This downward flow of the gas prevents droplets and an ambient atmosphere existing between the outer circumferential surface of the stationary cover 45 and the inner surface of the cleaning chamber 51 and also the mist in the cleaning chamber 51 from adhering again to the substrate W.

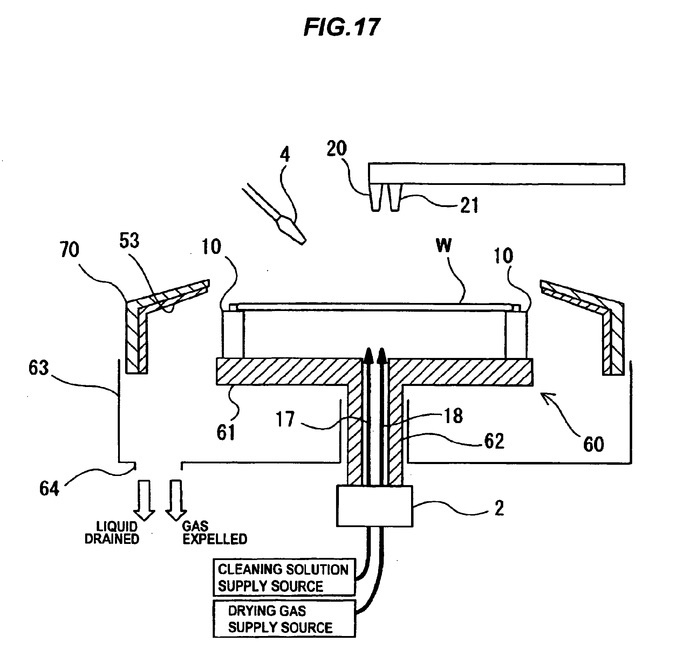

FIG 17 is a schematic vertical cross-sectional view of a substrate cleaning apparatus according to a reference example of the present invention.

As shown in FIG 17, the substrate cleaning apparatus includes a substrate holding mechanism 60 configured to hold a substrate W horizontally, a motor (rotating mechanism) 2 configured to rotate the substrate W about its own central axis via the substrate holding mechanism 60, a stationary cover 70 provided around the substrate W, and a front nozzle 4 for supplying pure water as a cleaning solution onto the front surface of the substrate W. The substrate holding mechanism 60 includes a stage 61, a hollow support shaft 62 supporting the stage 61, and a plurality of chucks 10 mounted on an upper surface of the stage 61.

The support shaft 62 houses therein a back nozzle 17 coupled to a cleaning solution supply source and a gas nozzle 18 coupled to a drying gas supply source. The cleaning solution supply source stores pure water as a cleaning solution therein, and supplies the pure water through the back nozzle 17 to the rear surface of the substrate W. The drying gas supply source stores an N₂ gas or dry air as a drying gas therein, and supplies the drying gas through the gas nozzle 18 to the rear surface of the substrate W.

The front nozzle 4 is oriented toward the center of the substrate W. The front nozzle 4 is coupled to a pure water supply source (i.e., a cleaning solution supply source), not shown, and supplies pure water from the pure water supply source onto the center of the front surface of the substrate W. Two parallel nozzles 20 and 21 for performing Rotagoni drying are disposed above the substrate W. The nozzle 20 is for supplying IPA vapor (a mixture of isopropyl alcohol and an N₂ gas) onto the front surface of the substrate W. The nozzle 21 is for supplying pure water onto the front surface of the substrate W in order to prevent the front surface of the substrate W from being dried. The nozzles 20 and 21 are movable in the radial direction of the substrate W.

The stationary cover 70 has an inner circumferential surface that is inclined radially inwardly. The stationary cover 70 has an upper end positioned above the substrate W. A liquid absorber 53 is fixed to the inner circumferential surface of the stationary cover 70. The liquid absorber 53 covers substantially the entire inner circumferential surface of the stationary cover 70. The liquid absorber 53 may be made of a sponge of PVA (polyvinyl alcohol), a porous material, or a mesh cloth. The liquid absorber 53 should preferably be hydrophilic for easily trapping the liquid from the substrate W. The liquid absorber 53 should also preferably have continuous pores therein so as to lead the trapped liquid downwardly through the liquid absorber 53.

A liquid reservoir 63 for recovering a liquid (e.g., the pure water supplied as the cleaning solution from the front nozzle 4 and the back nozzle 17 and the pure water supplied from the nozzle 21) is disposed below the stage 61 and the stationary cover 70. The liquid reservoir 63 has an outlet port 64 in its bottom. The outlet port 64 is coupled to a suction source (not shown), so that the liquid, recovered by the liquid reservoir 63, is forced to be discharged together with an ambient gas through the outlet port 64.

The substrate cleaning apparatus in this example is operable to perform a drying process on the substrate W in accordance with the same processing sequence as the first embodiment. Specifically, the motor 2 is energized to rotate the substrate W. Then, the front nozzle 4 and the back nozzle 17 supply the pure water onto the front surface and the rear surface of the substrate W, respectively, so as to rinse the substrate W in its entirety with the pure water. The pure water is removed from the rotating substrate W, captured by the stationary cover 70, and recovered by the liquid reservoir 63. While the substrate W is thus rinsed, the two nozzles 20 and 21 are in their given standby positions away from the substrate W.

Then, supply of the pure water is stopped, and the front nozzle 4 is moved to its given standby position away from the substrate W. The two nozzles 20 and 21 are moved to their operating positions above the substrate W. While the substrate W is being rotated at a low speed ranging from 150 to 300 min⁻¹, the nozzle 20 supplies the IPA vapor and the nozzle 21 supplies the pure water onto the front surface of the substrate W During this operation, the back nozzle 17 supplies the pure water to the rear surface of the substrate W. The two nozzles 20 and 21 are simultaneously moved in the radial direction of the substrate W, whereby the front surface (upper surface) of the substrate W is dried.

Thereafter, the two nozzles 20 and 21 are moved to their standby positions, and supply of the pure water from the back nozzle 17 is stopped. Then, the substrate W is rotated at a high speed ranging from 1000 to 1500 min⁻¹, removing the pure water from the rear surface of the substrate W. During this operation, the gas nozzle 18 supplies the drying gas to the rear surface of the substrate W. In this manner, the rear surface of the substrate W is dried.

In this example with the above-described structures, the liquid absorber 53 is able to absorb the impact of the liquid impinging upon the stationary cover 70.

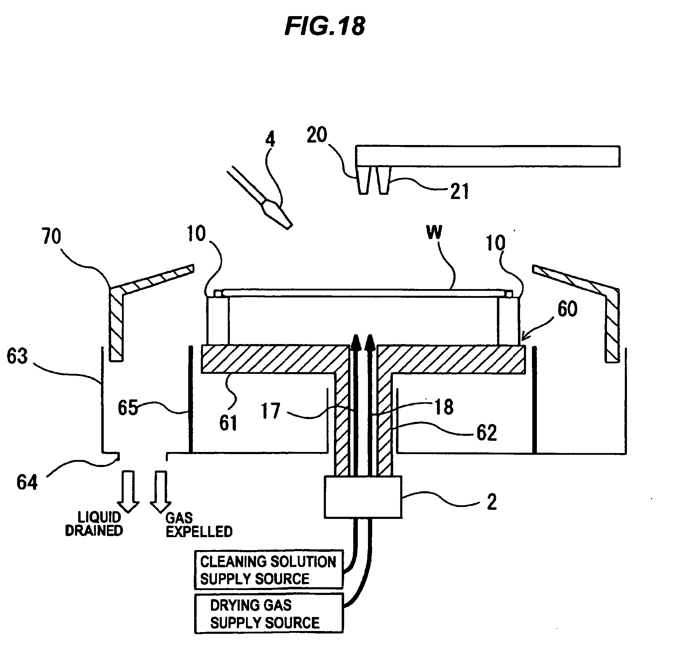

FIG 18 is a schematic vertical cross-sectional view of a substrate cleaning apparatus according to another reference example of the present invention. Structural and operational details of the substrate cleaning apparatus shown in FIG 18, which will not be described below, are the same as those of the substrate cleaning apparatus shown in FIG 17, and will not be described repetitively.

As shown in FIG 18, the substrate cleaning apparatus includes a hollow cylindrical shield cover 65 that is shaped so as to surround the stage 61 and the support shaft 62. The shield cover 65 has an upper end positioned at substantially the same height as the stage 61 and a lower end fixed to the liquid reservoir 63. In this example, the above-described liquid absorber 53 is not provided. Since the stage 61 and the support shaft 62 are covered with the shield cover 65, a swirling flow of an ambient gas is prevented from being formed when the stage 61 and the support shaft 62 are rotated. As a result, a mist of the liquid, which would otherwise be carried by such a swirling flow of the ambient gas, is also prevented from adhering again to the surface of the substrate W.

The spin cover according to the first embodiment may be added to the substrate cleaning apparatus shown in FIGS. 17 and 18.

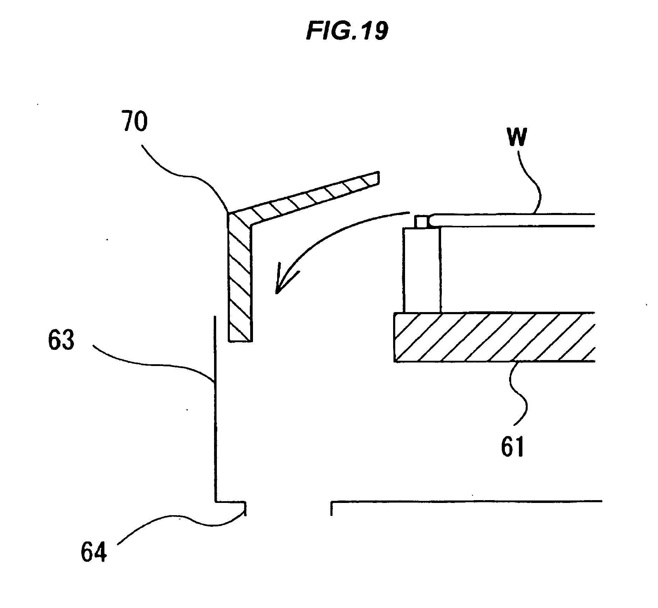

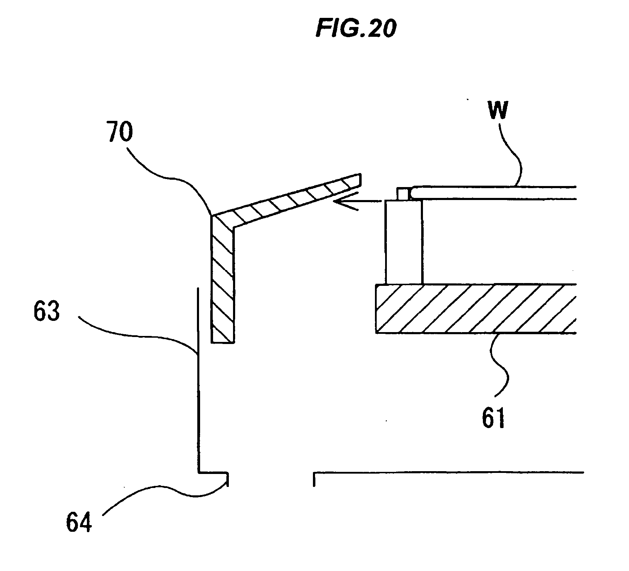

FIGS. 19 and 20 are schematic vertical cross-sectional views of a substrate cleaning apparatus according to still another reference example of the present invention. Structural and operational details of the substrate cleaning apparatus shown in FIGS. 19 and 20, which will not be described below, are the same as those of the substrate cleaning apparatus shown in FIG 17, and will not be described repetitively.

In this example, the stationary cover 70 is vertically movable. As described above, the substrate W is rotated at different speeds when the front surface of the substrate W is dried and when the rear surface of the substrate W is dried. Therefore, it is preferable to change a position of the stationary cover 70 depending on which side of the substrate W is to be dried. Specifically, when the front surface of the substrate W is dried, the stationary cover 70 is in a normal position as shown in FIG 19. As described above, the substrate W is rotated at a low speed when the front surface of the substrate W is dried. Therefore, the droplets, removed from the rotating substrate W, fall freely and then impinge upon the inner circumferential surface of the stationary cover 70. Since a distance between the stationary cover 70 and the periphery of the substrate W is large, the droplets, impinging upon the stationary cover 70, hardly bounce back to the substrate W.

When the rear surface of the substrate W is dried, the substrate W is rotated at a high speed. Therefore, the droplets, removed from the rotating substrate W, travel substantially linearly and impinge upon the inner circumferential surface of the stationary cover 70 at a high speed, as shown in FIG 20. In addition, as the chucks 10 and the stage 61 are rotated at a high speed, the gas around the substrate W is disturbed, forming a swirling flow. This swirling flow of the gas is not preferable because it could carry the droplets and the mist to the surface of the substrate W. According to this example, the rear surface of the substrate W is dried with the stationary cover 70 being in a lowered position. Specifically, the stationary cover 70 is lowered to the position in which the upper end of the stationary cover 70 is at substantially the same height as the substrate W. In this position, the distance between the periphery of the substrate W and the stationary cover 70 is small. Therefore, the droplets and the mist are prevented from flowing from the rear surface to the front surface of the substrate W.

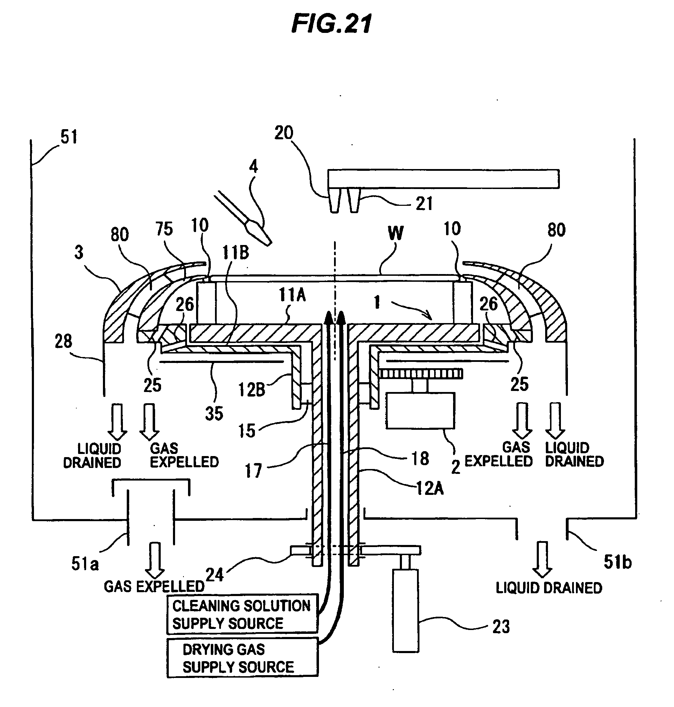

FIG 21 is a schematic vertical cross-sectional view of a substrate cleaning apparatus according to a sixth embodiment of the present invention. Those parts of the substrate cleaning apparatus according to the sixth embodiment, which are identical to those of the substrate cleaning apparatus according to the first embodiment, are denoted by identical reference characters, and will not be described in detail below. Operational details of the substrate cleaning apparatus according to the sixth embodiment, which will not be described below, are the same as those of the substrate cleaning apparatus according to the first embodiment.

As shown in FIG 21, an inner spin cover 75 is provided radially inwardly of the spin cover 3. This inner spin cover 75 is fixed to the second stage 11B of the stage 11. The spin cover (first spin cover) 3 and the inner spin cover (second spin cover) 75 are coupled to each other by a plurality of support arms 80. Therefore, the inner spin cover 75 and the spin cover 3 are rotatable together with each other. A gap is formed between the inner spin cover 75 and the spin cover 3.

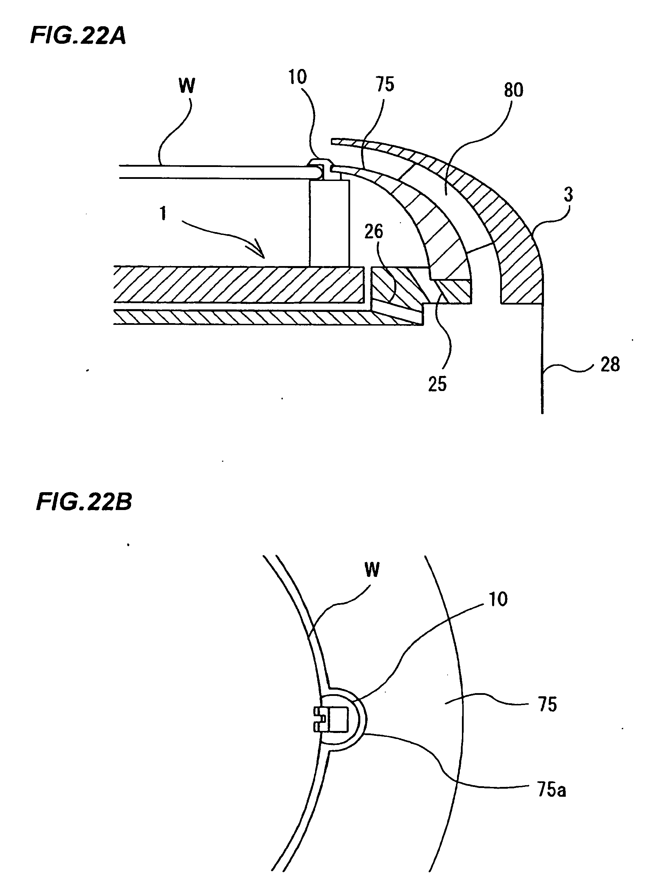

FIG 22A is an enlarged vertical cross-sectional view of the inner spin cover 75 and the spin cover 3, and FIG 22B is a plan view of the inner spin cover 75 and chuck 10. The inner spin cover 75 has an outer circumferential surface having a smooth arcuate vertical cross section. An angle of the outer circumferential surface of the inner spin cover 75 with respect to the horizontal plane increases gradually from a minimum at an upper end to a maximum at a lower end of the inner spin cover 75. More specifically, the angle of the outer circumferential surface of the inner spin cover 75 with respect to the horizontal plane is approximately 0 degree at the upper end thereof, and is approximately 90 degrees at the lower end thereof.

The upper end of the inner spin cover 75 is positioned slightly below the upper surface of the substrate W held by the chucks 10. In other words, the upper end of the outer circumferential surface of the inner spin cover 75 is positioned below the upper surface of the substrate W and the upper end of the inner circumferential surface of the inner spin cover 75 is positioned above the lower surface of the substrate W. The upper end of the inner spin cover 75 is located near the periphery of the substrate W. A diameter of the upper end of the inner spin cover 75 is slightly greater than the diameter of the substrate W. The inner circumferential surface of the inner spin cover 75 should also preferably have a smooth arcuate vertical cross section, as with the outer circumferential surface thereof. As shown in FIG 22B, the upper end of the inner spin cover 75 has a plurality of recesses 75a each having a shape corresponding to a shape of each chuck 10.

The outer circumferential surface of the inner spin cover 75 comprises smooth parabolic lines extending downwardly from the periphery of the substrate W. Therefore, when the substrate W is rotated, the liquid on the substrate W is led smoothly along the outer circumferential surface of the inner spin cover 75 in the downward direction under a surface tension of the liquid. Hence, the flow of the liquid is not broken into droplets and a mist. Since the upper end of the outer circumferential surface of the inner spin cover 75 is slightly lower than the upper surface of the substrate W, the liquid is less liable to be trapped in the gap between the substrate W and the inner spin cover 75. If the upper end of the outer circumferential surface of the inner spin cover 75 is higher than the upper surface of the substrate W, then the flow of the liquid from the substrate W is broken between the substrate W and the inner spin cover 75 and is turned into droplets and a mist. Accordingly, the upper end of the outer circumferential surface of the inner spin cover 75 lies at the same height as or, preferably, slightly below the upper surface of the substrate W.

The inner circumferential surface of the spin cover 3 has substantially the same shape as the outer circumferential surface of the inner spin cover 75. Specifically, the inner circumferential surface of the spin cover 3 has a smooth arcuate vertical cross section. An angle of the inner circumferential surface of the spin cover 3 with respect to the horizontal plane increases gradually from a minimum at the upper end to a maximum at the lower end of the spin cover 3. More specifically, the angle of the inner circumferential surface of the spin cover 3 with respect to the horizontal plane is approximately 0 degree at the upper end thereof, and is approximately 90 degrees at the lower end thereof. Although not shown in the drawings, the upper end of the spin cover 3 also has a plurality of recesses which are similar in shape to the recesses of the inner spin cover 75.

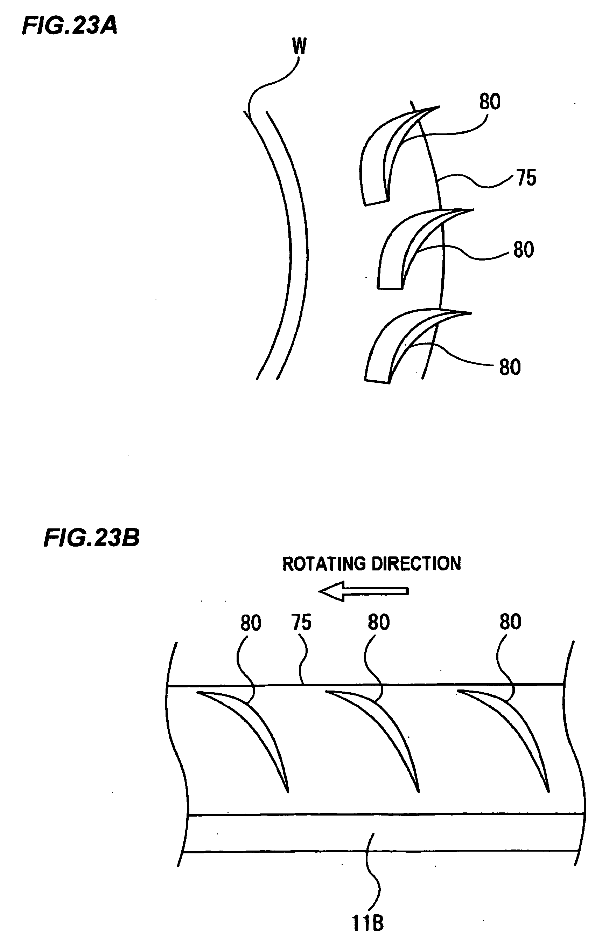

The support arms 80 are fixed to the outer circumferential surface of the inner spin cover 75 and the inner circumferential surface of the spin cover 3. Specifically, the support arms 80 are arranged in the gap between the outer circumferential surface of the inner spin cover 75 and the inner circumferential surface of the spin cover 3. FIG 23A is a plan view of the support arms 80 fixed to the inner spin cover as viewed from above, and FIG 23B is a view of the support arms 80 as viewed from a radially outward side. In FIGS. 23A and 23B, the spin cover 3 is not shown for explanation. Each of the support arms 80 has a shape of a blade, so that the support arms 80 produce a downward flow of a gas in the gap between the inner spin cover 75 and the spin cover 3 when the inner spin cover 75 and the spin cover 3 rotate.

The inner spin cover 75 and the spin cover 3 are rotated together with the substrate W. The liquid, e.g., pure water, supplied to the upper surface of the substrate W is moved from the substrate W to the inner spin cover 75 by the centrifugal force, and flows downwardly along the outer circumferential surface of the inner spin cover 75. During rotation, the support arms 80, which function as blades, form the downward flow of the gas in the gap between the inner spin cover 75 and the spin cover 3. Therefore, a mist and droplets of the liquid are forced to move downwardly by the downward flow of the gas, and are prevented from adhering to the surface of the substrate W. The gap between the inner spin cover 75 and the spin cover 3 is appropriately adjusted so as to allow the liquid to flow smoothly downwardly and to prevent the mist from entering the space above the substrate W.

The surfaces of the inner spin cover 75 and the spin cover 3 should preferably be a hydrophilic surface so as not to easily release the droplets once attached to the inner spin cover 75 and the spin cover 3. It is preferable that the outer circumferential surface of the inner spin cover 75 and/or the inner circumferential surface of the spin cover 3 have a spiral groove for leading the liquid on the inner spin cover 75 and the spin cover 3 downwardly.

The inner spin cover 75, the spin cover 3, and the substrate W are located in the cleaning chamber 51. The cleaning chamber 51 has a gas outlet 51a and a liquid outlet 51b in the bottom thereof A liquid, such as pure water, supplied to the substrate W is discharged through the liquid outlet 51b, and the gas forming the downward flow by the rotation of the support arms 80 is discharged through the gas outlet 51a. A vacuum pump may be coupled to the gas outlet 51a so that the gas is forced to be discharged from the cleaning chamber 51.

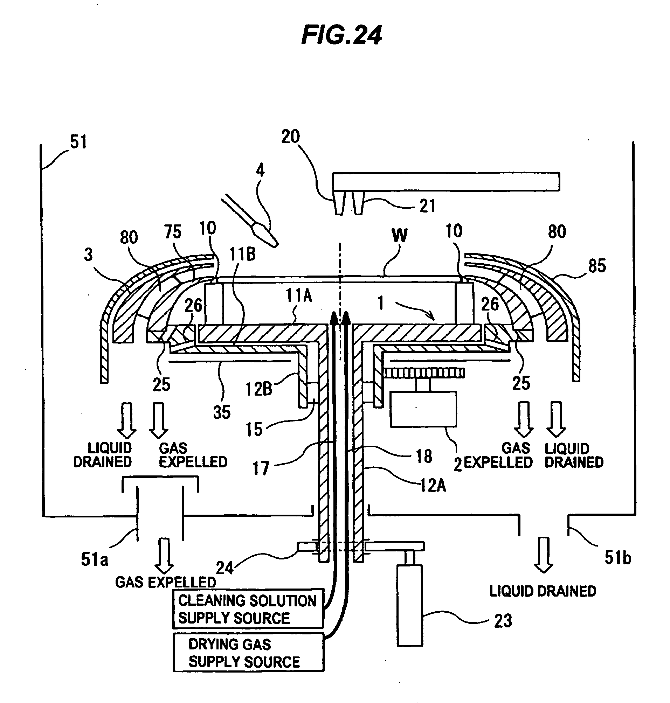

FIG 24 is a cross-sectional view showing a modification of the substrate cleaning apparatus according to the sixth embodiment of the present invention. In this modified example, a stationary cover 85 is added. As shown in FIG 24, this stationary cover 85 is provided around the spin cover 3. The stationary cover 85 is not rotatable, and has a lower end positioned below the lower end of the spin cover 3. Thus, the stationary cover 85 is shaped so as to cover the entire outer circumferential surface of the spin cover 3. A small gap is formed between the outer circumferential surface of the spin cover 3 and an inner circumferential surface of the stationary cover 85. Although not shown in the drawings, an upper end of the stationary cover 85 has a plurality of recesses each having a shape corresponding to a shape of each chuck 10. A diameter of the upper end of the stationary cover 85 is substantially the same as or slightly greater than the diameter of the upper end of the spin cover 3. The stationary cover 85 is provided for the same reasons why the above-described stationary cover 45 is provided.

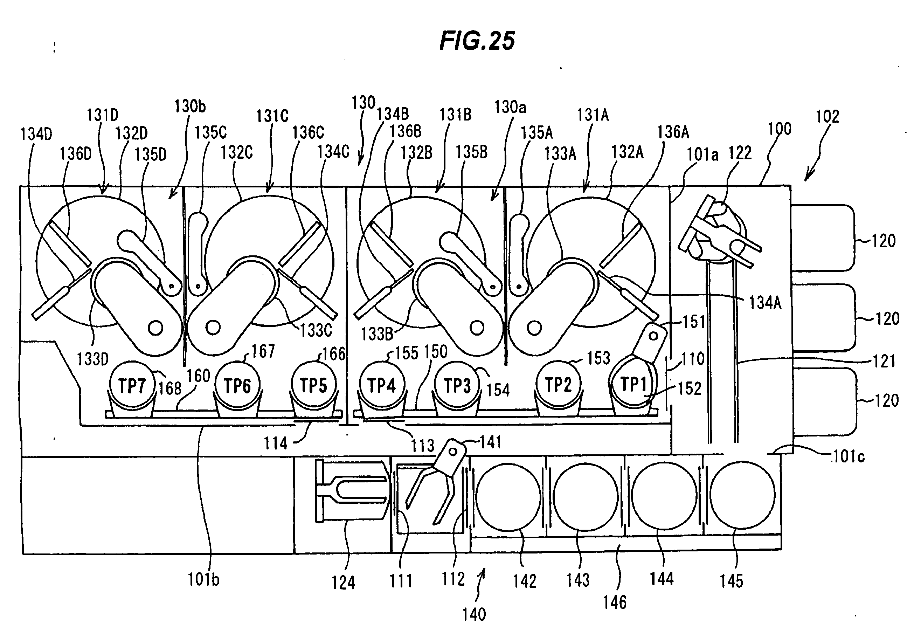

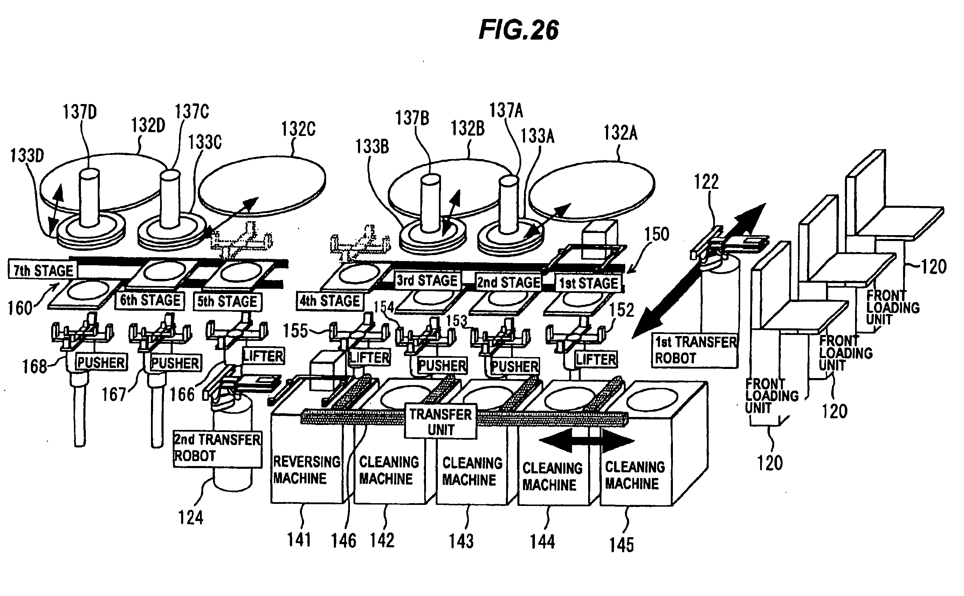

Next, an example of a polishing apparatus having the substrate cleaning apparatus according to the above-described embodiment of the present invention will be described. FIG 25 is a plan view of a polishing apparatus incorporating the substrate cleaning apparatus according to any one of the first to sixth embodiments of the present invention. FIG 26 is a schematic perspective view of the polishing apparatus shown in FIG 25. As shown in FIG 25, the polishing apparatus has a housing 100 in a rectangular form. An interior space of the housing 100 is divided into a loading and unloading section 102, a polishing section 130 (130a, 130b), and a cleaning section 140 by partition walls 101a, 101b, and 101c.

The loading and unloading section 102 has two or more front loading units 120 (three in FIG 25) on which wafer cassettes, each storing a number of substrates, are placed. The front loading units 120 are arranged adjacent to each other along a width direction of the polishing apparatus (a direction perpendicular to a longitudinal direction of the polishing apparatus). Each of the front loading units 120 can receive thereon an open cassette, an SMIF (Standard Manufacturing Interface) pod, or a FOUP (Front Opening Unified Pod). The SMIF and FOUP are a hermetically sealed container which houses a wafer cassette therein and covers it with a partition wall to provide an interior environment isolated from an external space.

Further, the loading and unloading section 102 has a moving mechanism 121 extending along an arrangement direction of the front loading units 120. A first transfer robot 122 is installed on the moving mechanism 121 and is movable along the arrangement direction of the front loading units 120. This first transfer robot 122 is operable to move on the moving mechanism 121 so as to access the wafer cassettes mounted on the front loading units 120. The first transfer robot 122 has vertically arranged two hands, which are separately used. For example, the upper hand can be used for returning a polished substrate to the wafer cassette, and the lower hand can be used for transferring a non-polished substrate.

The loading and unloading section 102 is required to be a cleanest area. Therefore, pressure in the interior of the loading and unloading section 102 is kept higher at all times than pressures in the exterior space of the apparatus, the polishing section 130 and the cleaning section 140. Further, a filter fan unit (not shown in the drawings) having a clean air filter, such as HEPA filter or ULPA filter, is provided above the moving mechanism 121 of the first transfer robot 122. This filter fan unit removes particles, toxic vapor, and toxic gas from air to produce clean air, and forms a downward flow of the clean air at all times.

The polishing section 130 is an area where a substrate is polished. This polishing section 130 includes a first polishing section 130a having a first polishing unit 131A and a second polishing unit 131B therein, and a second polishing section 130b having a third polishing unit 130C and a fourth polishing unit 131D therein. As shown in FIG 25, the first polishing unit 131A, the second polishing unit 131B, the third polishing unit 131C, and the fourth polishing unit 131D are arranged along the longitudinal direction of the polishing apparatus.

The first polishing unit 131A includes a polishing table 132A holding a polishing pad, a top ring 133A configured to hold a substrate and pressing the substrate against a polishing surface of the polishing pad on the polishing table 132A so as to polish the substrate, a polishing liquid supply nozzle 134A for supplying a polishing liquid (e.g., slurry) or a dressing liquid (e.g., pure water) onto the polishing surface of the polishing pad, a dresser 135A for dressing the polishing pad, and an atomizer 136A having a nozzle for ejecting a mixture of a liquid (e.g., pure water) and a gas (e.g., nitrogen) in an atomized state to the polishing surface.

Similarly, the second polishing unit 131B includes a polishing table 132B, a top ring 133B, a polishing liquid supply nozzle 134B, a dresser 135B, and an atomizer 136B. The third polishing unit 131C includes a polishing table 132C, a top ring 133C, a polishing liquid supply nozzle 134C, a dresser 135C, and an atomizer 136C. The fourth polishing unit 131D includes a polishing table 132D, a top ring 133D, a polishing liquid supply nozzle 134D, a dresser 135D, and an atomizer 136D.

A first linear transporter 150 is provided in the first polishing section 130a. This first linear transporter 150 is configured to transfer a substrate between four transferring positions located along the longitudinal direction of the polishing apparatus (hereinafter, these four transferring positions will be referred to as a first transferring position TP1, a second transferring position TP2, a third transferring position TP3, and a fourth transferring position TP4 in the order from the loading and unloading section 102). A reversing machine 151 for reversing a substrate transferred from the first transfer robot 122 is disposed above the first transferring position TP1 of the first linear transporter 150. A vertically movable lifter 152 is disposed below the first transferring position TP1. A vertically movable pusher 153 is disposed below the second transferring position TP2, a vertically movable pusher 154 is disposed below the third transferring position TP3, and a vertically movable lifter 155 is disposed below the fourth transferring position TP4.

In the second polishing section 130b, a second linear transporter 160 is provided next to the first linear transporter 150. This second linear transporter 160 is configured to transfer a substrate between three transferring positions located along the longitudinal direction of the polishing apparatus (hereinafter, these three transferring positions will be referred to as a fifth transferring position TP5, a sixth transferring position TP6, and a seventh transferring position TP7 in the order from the loading and unloading section 102). A vertically-movable lifter 166 is disposed below the fifth transferring position TP5 of the second linear transporter 160, a vertically-movable pusher 167 is disposed below the sixth transferring position TP6, and a vertically-movable pusher 168 is disposed below the seventh transferring position TP7.

As shown in FIG 26, the first linear transporter 150 has four transfer stages: a first stage, a second stage, a third stage, and a fourth stage, which are linearly movable in a reciprocating manner. These transfer stages have a two-line structure including an upper line and a lower line. Specifically, the first transfer stage, the second transfer stage, and the third transfer stage are disposed on the lower line, and the fourth transfer stage is disposed on the upper line.

The lower transfer stages and the upper transfer stage can freely move without interfering with each other, because they are provided at different heights. The first transfer stage transfers a substrate between the first transferring position TP1 and the second transferring position (i.e., a substrate receiving/delivering position) TP2. The second transfer stage transfers a substrate between the second transferring position TP2 and the third transferring position (i.e., a substrate receiving/delivering position) TP3. The third transfer stage transfers a substrate between the third transferring position TP3 and the fourth transferring position TP4. The fourth transfer stage transfers a substrate between the first transferring position TP1 and the fourth transferring position TP4.

The second linear transporter 160 has substantially the same structures as those of the first linear transporter 150. Specifically, a fifth transfer stage and a sixth transfer stage are disposed on an upper line, and a seventh transfer stage is disposed on a lower line. The fifth transfer stage transfers a substrate between the fifth transferring position TP5 and the sixth transferring position (i.e., a substrate receiving/delivering position) TP6. The sixth transfer stage transfers a substrate between the sixth transferring position TP6 and the seventh transferring position (i.e., a substrate receiving/delivering position) TP7. The seventh transfer stage transfers a substrate between the fifth transferring position TP5 and the seventh transferring position TP7.

As can be understood from the fact that a slurry is used during polishing, the polishing section 130 is the dirtiest area. Therefore, in order to prevent particles from spreading out of the polishing section 130, a gas is discharged from surrounding spaces of the respective polishing tables. In addition, pressure in the interior of the polishing section 130 is set to be lower than pressures in the exterior of the apparatus, the cleaning section 140, and the loading and unloading section 102, whereby scattering of particles is prevented. Typically, discharge ducts (not shown in the drawings) are provided below the polishing tables, respectively, and filters (not shown in the drawings) are provided above the polishing tables, so that downward flows of clean air are formed from the filters to the discharge ducts.

The cleaning section 140 is an area where a polished substrate is cleaned. The cleaning section 140 includes a second transfer robot 124, a reversing machine 141 for reversing a substrate received from the second transfer robot 124, four cleaning units 142-145 for cleaning a polished substrate, and a transfer unit 146 for transferring a substrate between the reversing machine 141 and the cleaning units 142-145.

The second transfer robot 124, the reversing machine 141, and the cleaning units 142-145 are arranged in series along the longitudinal direction of the polishing apparatus. A filter fan unit (not shown in the drawings), having a clean air filter, is provided above the cleaning units 142-145. This filter fan unit is configured to remove particles from an air to produce a clean air, and to form downward flow of the clean air at all times. Pressure in the cleaning section 140 is kept higher than pressure in the polishing section 130, so that particles in the polishing section 130 is prevented from flowing into the cleaning section 140.

The transfer unit 146 has plural arms configured to hold substrates, so that plural substrates can be moved horizontally together with each other by the arms between the reversing machine 141 and the cleaning units 142-145. The cleaning unit 142 and the cleaning unit 143 may comprise, for example, a roll type cleaning unit having upper and lower roll-shaped sponges which are rotated and pressed against front and rear surfaces of a substrate to thereby clean the front and rear surfaces of the substrate. The cleaning unit 144 may comprise, for example, a pencil type cleaning unit having a hemispherical sponge which is rotated and pressed against a substrate to clean the substrate. The cleaning unit 145 comprises the above-described substrate cleaning apparatus according to any one of the embodiments. In the cleaning units 142-144, a megasonic type cleaning unit, which applies ultrasonic waves to a cleaning liquid to clean a substrate, may be provided in addition to the roll type cleaning unit or the pencil type cleaning unit described above.

A shutter 110 is provided between the reversing machine 151 and the first transfer robot 122. When transferring the substrate, the shutter 110 is opened, and the substrate is delivered between the first transfer robot 122 and the reversing machine 151. Shutters 111, 112, 113, and 114 are also provided between the reversing machine 141 and the second transfer robot 124, between the reversing machine 141 and the cleaning unit 142, between the first polishing section 130a and the second transfer robot 124, and between the second polishing section 130b and the second transfer robot 124, respectively. These shutters 111, 112, 113, and 114 are opened when a substrate is transferred.

The polishing pad (not shown) is mounted on the polishing table 132A. The polishing table 132A is coupled to a motor (not shown) disposed therebelow, and is rotatable about its own axis. As shown in FIG 26, the top ring 133A is coupled to a top ring shaft 137A, which is coupled to a motor and an elevating cylinder (not shown). The top ring 133A can thus be moved vertically and rotated about the top ring shaft 137A. The substrate to be polished is attracted to and held on a lower surface of the top ring 133A by a vacuum attraction or the like. The upper surface of the polishing pad constitutes the polishing surface used for sliding contact with the substrate W.

The substrate, held on the lower surface of the top ring 133A, is rotated and pressed by the top ring 133A against the polishing pad on the rotating polishing table 132A. The polishing liquid is supplied from the polishing liquid supply nozzle 134A onto the polishing surface (upper surface) of the polishing pad. The substrate W is polished in the presence of the polishing liquid between the substrate W and the polishing pad. The polishing table 132A and the top ring 133A constitute a mechanism of providing relative movement between the substrate W and the polishing surface. The second polishing unit 131B, the third polishing unit 131C, and the fourth polishing unit 131D have the same structures as the first polishing unit 131A, and therefore the detailed descriptions thereof are omitted.

The polishing apparatus having the above structures can perform both serial processing in which a single substrate is successively polished by the four polishing units and parallel processing in which two substrates are polished simultaneously.

When serial processing is performed, a substrate is transferred on the following route: the wafer cassette of the front loading unit 120 → the first transfer robot 122 → the reversing machine 151 → the lifter 152 → the first transfer stage of the first linear transporter 150 → the pusher 153 → the top ring 133A → the polishing table 132A → the pusher 153 → the second transfer stage of the first linear transporter 150 → the pusher 154 → the top ring 133B → the polishing table 132B → the pusher 154 → the third transfer stage of the first linear transporter 150 → the lifter 155 → the second transfer robot 124 → the lifter 166 → the fifth transfer stage of the second linear transporter 160 → the pusher 167 → the top ring 133C → the polishing table 132C → the pusher 167 → the sixth transfer stage of the second linear transporter 160 → the pusher 168 → the top ring 133D → the polishing table 132D → the pusher 168 → the seventh transfer stage of the second linear transporter 160 → the lifter 166 → the second transfer robot 124 → the reversing machine 141 → the transfer unit 146 → the cleaning unit 142 → the transfer unit 146 → the cleaning unit 143 → the transfer unit 146 → the cleaning unit 144 → the transfer unit 146 → the cleaning unit 145 → the first transfer robot 122 → the wafer cassette of the front loading unit 120.

When parallel processing is performed, a substrate is transferred on the following route: the wafer cassette of the front loading unit 120 → the first transfer robot 122 → the reversing machine 151 → the lifter 152 → the first transfer stage of the first linear transporter 150 → the pusher 153 → the top ring 133A → the polishing table 132A → the pusher 153 → the second transfer stage of the first linear transporter 150 → the pusher 154 → the top ring 133B → the polishing table 132B → the pusher 154 → the third transfer stage of the first linear transporter 150 → the lifter 155 → the second transfer robot 124 → the reversing machine 141 → the transfer unit 146 → the cleaning unit 142 → the transfer unit 146 → the cleaning unit 143 → the transfer unit 146 → the cleaning unit 144 → the transfer unit 146 → the cleaning unit 145 → the first transfer robot 122 → the wafer cassette of the front loading unit 120.

Another substrate is transferred on the following route: the wafer cassette of the front loading unit 120 → the first transfer robot 122 → the reversing machine 151 → the lifter 152 → the fourth transfer stage of the first linear transporter 150 → the lifter 155 → the second transfer robot 124 → the lifter 166 → the fifth transfer stage of the second linear transporter 160 → pusher 167 → the top ring 133C → the polishing table 132C → the pusher 167 → the sixth transfer stage of the second linear transporter 160 → the pusher 168 → the top ring 133D → the polishing table 132D → the pusher 168 → the seventh transfer stage of the second linear transporter 160 → the lifter 166 → the second transfer robot 124 → the reversing machine 141 1 → the transfer unit 146 → the cleaning unit 142 → the transfer unit 146 → the cleaning unit 143 → the transfer unit 146 → the cleaning unit 144 → the transfer unit 146 → the cleaning unit 145 → the first transfer robot 122 → the wafer cassette of the front loading unit 120.

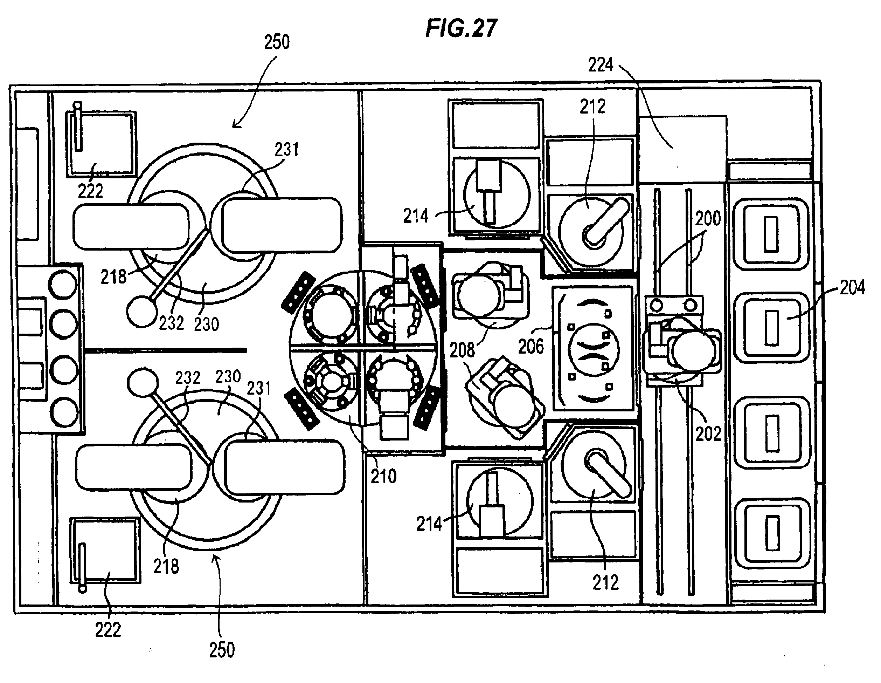

Another polishing apparatus incorporating the substrate cleaning apparatus according to any one of the first to sixth embodiments will be described below. FIG 27 is a plan view of another polishing apparatus incorporating the substrate cleaning apparatus according to any one of the first to sixth embodiments of the present invention.

As shown in FIG 27, the polishing apparatus includes a loading and unloading section 201 for housing a plurality of wafer cassettes 204 in which a number of substrates is stored. A transfer robot 202 having two hands is installed on a moving mechanism 200 so as to access the wafer cassettes 204 in the loading and unloading section 201. The moving mechanism 200 uses a linear motor mechanism, which allows the transfer robot 202 to stably carry a large-diameter and heavy substrate at a high speed.

The polishing apparatus also includes two cleaning units 212 arranged on an opposite side of the wafer cassettes 204 with respect to the moving mechanism 200 of the transfer robot 202. Each of the cleaning units 212 is the substrate cleaning apparatus according to any one of the first to sixth embodiments of the present invention. The cleaning units 212 are arranged in respective positions that can be reached by the hands of the transfer robot 202. A wafer station 206 having four substrate placement tables is disposed between the two cleaning units 212. This wafer station 206 is located in a position that can be reached by the hands of the transfer robot 202.

Two transfer robots 208 are disposed in respective positions where hands thereof can reach the respective cleaning units 212 and the wafer station 206. Two cleaning units 214 are disposed adjacent to the cleaning units 212, respectively. These cleaning units 214 are located in positions such that the hands of the transfer robots 208 can reach the cleaning units 214, respectively. A rotary transporter 210 is disposed in a position that can be reached by the hands of the transfer robots 208. Two polishing units 250 are disposed in positions where the polishing units 250 can transfer substrates to and from the rotary transporter 210. Instead of the two transfer robots 208, a single transfer robot 208 may be provided.

The polishing apparatus has an ITM (In-line Thickness Monitor) 224 as a measuring unit for measuring a surface state, such as a film thickness, of a substrate which has been cleaned and dried. This ITM 224 is operable to perform measuring before or after the substrate is polished. As shown in FIG 27, the ITM 224 is located on an extension of the moving mechanism 200, or in other words, at an end of the moving mechanism 200. Before the transfer robot 202 transfers a polished substrate back into one of the wafer cassettes 204 or after the transfer robot 202 removes a substrate to be polished from one of the wafer cassettes 204, the ITM 224 measures a polishing state of a copper film or a barrier film on the surface of the substrate (e.g., a semiconductor wafer), based on an optical signal that is applied to and reflected on the substrate using an optical means.

Each of the polishing units 250 includes a polishing table 230, a top ring 231, a polishing solution supply nozzle 232 for supplying a polishing solution to a polishing pad (not shown) on the polishing table 230, a dresser 218 for dressing the polishing pad, and a water tank 222 storing water for use in cleaning the dresser 218.

Operations of the polishing apparatus shown in FIG 27 will be described below.

The wafer cassettes 204 storing a number of substrates each having an electrically conductive film, such as a copper film, formed on its surface are set in the loading and unloading section 201. The transfer robot 202 removes a substrate from one of the wafer cassettes 204, and places the removed substrate on the wafer station 206. One of the transfer robots 208 receives the substrate from the wafer station 206, turns it upside down, if necessary, and transfers it to the rotary transporter 210. The rotary transporter 210 is rotated in a horizontal plane, and the substrate on the rotary transporter 210 is held by the top ring 231 of one of the polishing units 250.

The substrate, held by the top ring 231, is moved to a polishing position above the polishing table 230. While the top ring 231 and the polishing table 230 are in rotation, the substrate is lowered and pressed against the polishing surface of the polishing pad. The substrate is polished while the polishing solution is supplied from the polishing solution supply nozzle 232 onto the polishing surface.

The polished substrate is transferred via the rotary transporter 210 to the transfer robot 208, which turns the substrate upside down, if necessary, and delivers the substrate to one of the cleaning units 214. In the polishing unit 250 which has performed the polishing process, the polishing surface of the polishing pad is dressed by the dresser 218 so as to be ready for polishing a next substrate.

The cleaning unit 214 cleans and rinses the surface of the substrate and then dries the substrate. The dried substrate is then transferred to and placed on the wafer station 206 by the transfer robot 208. The transfer robot 202 removes the dried substrate from the wafer station 206, and transports the substrate to one of the cleaning units 212, where the substrate is cleaned and dried. The cleaned and dried substrate is returned by the transfer robot 202 to the original wafer cassette 204.

Since the polishing apparatus has two sets of polishing units 250, cleaning units 212, and cleaning units 214, the polishing apparatus can perform a series of processes including polishing, cleaning, and drying on two substrates simultaneously. A single substrate may be polished by the two polishing units 250.

Although certain preferred embodiments of the present invention have been shown and described in detail, it should be understood that various changes and modifications may be made within a scope of technical concept defined by claims, the specification, and the drawings.

## Claims

1. A substrate cleaning and drying apparatus comprising:
a substrate holding mechanism (1) configured to hold a substrate (W) horizontally;
a rotating mechanism (2) configured to rotate the substrate (W) held by said substrate holding mechanism (1);
a liquid supply nozzle (4) for supplying a cleaning solution to the substrate (W); and
a spin cover (3) provided around the substrate (W) and rotatable at substantially the same speed as the substrate (W),
wherein said spin cover (3) has an inner circumferential surface shaped so as to surround the substrate (W), and said inner circumferential surface is, from a lower end to an upper end thereof, inclined radially inwardly,
said apparatus being **characterized in that**
said inner circumferential surface of said spin cover (3) has an arcuate vertical cross section comprising a curved line, and an angle (θ) of said inner circumferential surface with respect to a horizontal plane increases gradually from a minimum (θ1) at the upper end to a maximum (θ2) at the lower end of said inner circumferential surface.

2. The substrate cleaning and drying apparatus according to claim 1, further comprising a stationary cover (45) shaped so as to cover an entire outer circumference of said spin cover (3).

3. The substrate cleaning and drying apparatus according to claim 1, further comprising a relative movement mechanism (23) configured to provide relative movement between the substrate (W) and said spin cover (3) along a rotational axis of the substrate (W).

4. The substrate cleaning and drying apparatus according to claim 1, wherein
said spin cover (3) is mounted on said substrate holding mechanism (1);
said substrate holding mechanism (1) has a discharge hole (25) having an upper opening positioned at a lower end of said spin cover (3); and
said discharge hole (25) is inclined downwardly outwardly.

5. The substrate cleaning and drying apparatus according to claim 1, further comprising a liquid absorber (53) provided on said inner circumferential surface of said spin cover (3).

6. The substrate cleaning and drying apparatus according to claim 1, further comprising an inner spin cover (75) provided radially inwardly of said spin cover (3), said inner spin cover (75) being rotatable together with said spin cover (3).

7. The substrate cleaning and drying apparatus according to claim 6, wherein
said inner spin cover (75) has an outer circumferential surface having an arcuate vertical cross section; and
said outer circumferential surface of the inner spin cover (75) has an upper end lying at the same height as or slightly below an upper surface of the substrate (W) held by said substrate holding mechanism (1).

8. The substrate cleaning and drying apparatus according to claim 6, further comprising support arms (80) configured to couple said inner spin cover (75) and said spin cover (3) to each other, said support arms (80) being disposed in a gap between said inner spin cover (75) and said spin cover (3) and being shaped so as to produce a downward flow of a gas in the gap when said inner spin cover (75) and said spin cover (3) rotate.

## Patentansprüche

1. Eine Substratreinigungs- und Trocknungsvorrichtung, wobei die Vorrichtung Folgendes aufweist:
einen Substrathaltemechanismus (1), der so konfiguriert ist, um ein Substrat (W) horizontal zu halten;
einen Drehmechanismus (2), der konfiguriert ist, um das Substrat (W), das von dem Substrathaltemechanismus (1) gehalten wird, zu drehen;
eine Flüssigkeitsversorgungsdüse (4), zum Liefern einer Reinigungslösung an das Substrat (W); und
eine Drehabdeckung (3), die um das Substrat (W) herum vorgesehen ist, und drehbar ist mit im Wesentlichen derselben Geschwindigkeit, wie das Substrat (W),
wobei die Drehabdeckung (3) eine innere Umfangsfläche aufweist, die so ausgebildet ist, dass sie das Substrat (W) umgibt, und wobei die innere Umfangsfläche, von einem unteren Ende zu einem oberen Ende davon, radial nach innen geneigt ist, wobei
die Vorrichtung **dadurch gekennzeichnet ist, dass**
die innere Umfangsfläche der Drehabdeckung (3) einen bogenförmigen vertikalen Querschnitt aufweist, der eine Kurvenlinie aufweist und das ein Winkel (θ) der inneren Umfangsfläche bezüglich einer horizontalen Ebene allmählich ansteigt von einem Minimum (θ1) an dem oberen Ende zu einem Maximum (θ2) an dem unteren Ende der inneren Umfangsfläche.

2. Die Substratreinigungs- und Trocknungsvorrichtung nach Anspruch 1, wobei die Vorrichtung ferner eine stationäre Abdeckung (45) aufweist, die so geformt ist, dass sie einen gesamten äußeren Umfang der Drehabdeckung (3) abdeckt.

3. Die Substratreinigungs- und Trocknungsvorrichtung nach Anspruch 1, wobei die Vorrichtung ferner einen Relativbewegungsmechanismus (23) aufweist, der konfiguriert ist eine Relativbewegung zwischen dem Substrat (W) und der Drehabdeckung (3) entlang einer Drehachse des Substrats (W) vorzusehen.

4. Die Substratreinigungs- und Trocknungsvorrichtung nach Anspruch 1, wobei die Drehabdeckung (3) an dem Substrathaltemechanismus (1) angebracht ist;
der Substrathaltemechanismus (1) ein Auslassloch (25) mit einer oberen Öffnung, die an dem unteren Ende der Drehabdeckung (3) angeordnet ist, aufweist; und wobei
das Auslassloch (25) abwärts nach außen geneigt ist.

5. Die Substratreinigungs- und Trocknungsvorrichtung nach Anspruch 1, wobei die Vorrichtung ferner einen Flüssigkeitsaufnehmer (53) aufweist, der an der inneren Umfangsfläche der Drehabdeckung (3) vorgesehen ist.

6. Die Substratreinigungs- und Trocknungsvorrichtung nach Anspruch 1, wobei die Vorrichtung ferner eine innere Drehabdeckung (75) aufweist, die radial innen an der Drehabdeckung (3) vorgesehen ist, wobei die innere Drehabdeckung (75) drehbar zusammen mit der Drehabdeckung (3) ist.

7. Die Substratreinigungs- und Trocknungsvorrichtung nach Anspruch 6, wobei die innere Drehabdeckung (75) eine äußere Umfangsfläche mit einem bogenförmigen, vertikalen Querschnitt aufweist; und
die äußere Umfangsfläche der inneren Drehabdeckung (75) ein oberes Ende aufweist, das auf der gleichen Höhe oder leicht unter einer oberen Fläche des Substrats (W) liegt, das von dem Substrathaltemechanismus (1) gehalten wird.

8. Die Substratreinigungs- und Trocknungsvorrichtung nach Anspruch 6, wobei die Vorrichtung ferner Tragearme (80) aufweist, die konfiguriert sind, um die innere Drehabdeckung (75) und die Drehabdeckung (3) miteinander zu verbinden, wobei die Tragearme (80) in einem Spalt zwischen der inneren Drehabdeckung (75) und der Drehabdeckung (3) angeordnet sind und so geformt sind, um einen Abwärtsfluß von Gas in dem Spalt zu erzeugen, wenn sich die innere Drehabdeckung (75) und die Drehabdeckung (3) sich drehen.

## Revendications

1. Appareil de nettoyage et de séchage de substrat comprenant :
un mécanisme de maintien de substrat (1) configuré de façon à maintenir un substrat (W) de manière horizontale ;
un mécanisme de rotation (2) configuré de façon à faire tourner le substrat (W) maintenu par ledit mécanisme de maintien de substrat (1);
une buse de fourniture de liquide (4) destinée à fournir une solution de nettoyage sur le substrat (W); et
un couvercle rotatif (3) disposé autour du substrat (W) et pouvant tourner sensiblement à la même vitesse que le substrat (W);
dans lequel ledit couvercle rotatif (3) présente une surface circonférentielle intérieure qui présente une forme qui lui permet d'entourer le substrat (W), et ladite surface circonférentielle intérieure est inclinée de manière radiale vers l'intérieur, à partir d'une extrémité inférieure vers une extrémité supérieure de celui-ci ;
ledit appareil étant **caractérisé en ce que** :
ladite surface circonférentielle intérieure dudit couvercle rotatif (3) présente une section transversale verticale arquée qui comprend une ligne incurvée, et un angle (θ) de ladite surface circonférentielle intérieure par rapport à un plan horizontal qui croît de manière progressive à partir d'un minimum (θ1) au niveau de l'extrémité supérieure vers un maximum (θ2) au niveau de l'extrémité inférieure de ladite surface circonférentielle intérieure.

2. Appareil de nettoyage et de séchage de substrat selon la revendication 1, comprenant en outre un couvercle fixe (45) qui présente une forme qui lui permet de couvrir toute une circonférence extérieure dudit couvercle rotatif (3).

3. Appareil de nettoyage et de séchage de substrat selon la revendication 1, comprenant en outre un mécanisme de déplacement relatif (23) configuré de façon à fournir un déplacement relatif entre le substrat (W) et ledit couvercle rotatif (3) le long d'un axe de rotation du substrat (W).

4. Appareil de nettoyage et de séchage de substrat selon la revendication 1, dans lequel ledit couvercle rotatif (3) est monté sur ledit mécanisme de maintien de substrat (1) ;
ledit mécanisme de maintien de substrat (1) présente un orifice d'évacuation (25) qui présente une ouverture supérieure positionnée au niveau d'une extrémité inférieure dudit couvercle rotatif (3) ; et
ledit orifice d'évacuation (25) est incliné vers le bas et vers l'extérieur.

5. Appareil de nettoyage et de séchage de substrat selon la revendication 1, comprenant en outre un dispositif d'absorption de liquide (53) disposé sur ladite surface circonférentielle intérieure dudit couvercle rotatif (3).

6. Appareil de nettoyage et de séchage de substrat selon la revendication 1, comprenant en outre un couvercle rotatif intérieur (75) disposé de manière radiale vers l'intérieur dudit couvercle rotatif (3), ledit couvercle rotatif intérieur (75) pouvant tourner avec ledit couvercle rotatif (3).

7. Appareil de nettoyage et de séchage de substrat selon la revendication 6, dans lequel ledit couvercle rotatif intérieur (75) présente une surface circonférentielle extérieure qui présente une section transversale verticale arquée ; et
ladite surface circonférentielle extérieure dudit couvercle rotatif intérieur (75) présente une extrémité supérieure qui se trouve à la même hauteur que, ou légèrement en dessous de, la surface supérieure du substrat (W) maintenu par ledit mécanisme de maintien de substrat (1).

8. Appareil de nettoyage et de séchage de substrat selon la revendication 6, comprenant en outre des bras de support (80) configurés de façon à coupler entre eux ledit couvercle rotatif intérieur (75) et ledit couvercle rotatif (3), lesdits bras de support (80) étant disposés dans un espace entre ledit couvercle rotatif intérieur (75) et ledit couvercle rotatif (3) et présentant une forme qui permet de produire un flux de gaz vers le bas dans l'espace lorsque ledit couvercle rotatif intérieur (75) et ledit couvercle rotatif (3) tournent.
